# EUROPÄISCHE PATENTSCHRIFT

(11) **EP 4 556 732 B1**
(45) Veröffentlichungstag und Bekanntmachung des Hinweises auf die Patenterteilung: **21.01.2026**
(21) Anmeldenummer: 24210090.7
(22) Anmeldetag: 31.10.2024
(51) Int. Cl.: F16C 32/04

(54) **MAGNETLAGERVORRICHTUNG**
MAGNETIC BEARING DEVICE
DISPOSITIF DE PALIER MAGNÉTIQUE

(30) Priorität: 15.11.2023 EP 23210164
(43) Veröffentlichungstag der Anmeldung: 21.05.2025
(73) Patentinhaber: Levitronix GmbH, 8048 Zürich (CH)
(72) Erfinder: Stettler, Marcel, 4800 Zofingen (CH); Schneeberger, Thomas Dr., 3006 Bern (CH); Barletta, Natale Dr., 8048 Zürich (CH); Hinni, Patrick, 8754 Netstal (CH)
(74) Vertreter: IPS Irsch AG

(56) Entgegenhaltungen:
- EP-A1- 4 084 304
- US-A1- 2004 062 664
- US-A1- 2018 372 118

## Beschreibung

Die Erfindung betrifft einen Magnetlagervorrichtung gemäss dem Oberbegriff des unabhängigen Patentanspruchs.

Magnetlagervorrichtungen zur berührungslos magnetischen Lagerung eines Rotors haben den Vorteil, dass sie ohne mechanische Lager für den Rotor auskommen. Der Rotor wird mittels magnetischer Kräfte gelagert bzw. stabilisiert, die von einem Stator der Magnetlagervorrichtung generiert werden. Aufgrund der Abwesenheit von mechanischen Lagern eignen sich solche Magnetlagervorrichtungen insbesondere für Pump-, Misch-, Zentrifugier- oder Rührvorrichtungen, mit denen sehr empfindliche Substanzen gefördert werden, beispielsweise Blutpumpen, oder bei denen sehr hohe Anforderungen an die Reinheit gestellt werden, beispielsweise in der pharmazeutischen Industrie oder in der biotechnologischen Industrie, oder mit denen abrasive oder aggressive Substanzen gefördert werden, welche mechanische Lager sehr schnell zerstören würden, beispielsweise Pumpen oder Mischer für Slurry, Schwefel-, Phosphorsäure oder andere Chemikalien in der Halbleiterindustrie.

**In** der biotechnologischen Industrie werden solche Magnetlagervorrichtungen beispielsweise im Zusammenhang mit Bioreaktoren eingesetzt, z. B. bei Zentrifugalpumpen zum Fördern der Fluide in den oder aus dem Bioreaktor, oder bei Mischvorrichtungen, welche die Fluide in dem Bioreaktor durchmischen. **In** der Halbleiterindustrie werden solche Magnetlagervorrichtung nicht nur für das Fördern aggressiver oder abrasiver Substanzen verwendet, sondern beispielsweise auch für Rotationsvorrichtungen, mit denen Wafer rotiert werden.

Auch ist es bekannt, Magnetlagervorrichtungen für Viskosimeter zu verwenden.

Eine vorteilhafte und an sich bekannte Ausführungsform einer Magnetlagervorrichtung ist die Ausführung in Tempelbauweise, auf die sich auch die vorliegende Erfindung bezieht.

Das Charakteristische der Tempelbauweise ist es, dass der Stator der Magnetlagervorrichtung eine Mehrzahl von Spulenkernen aufweist, von denen jeder einen Längsschenkel umfasst, der sich von einem ersten Ende in einer axialen Richtung bis zu einem zweiten Ende erstreckt. Mit der axialen Richtung ist dabei diejenige Richtung gemeint, welche durch die Solldrehachse des Rotors definiert ist, welcher mit der Magnetlagervorrichtung gelagert wird. Die Solldrehachse ist diejenige Drehachse, um welche der Rotor im Betriebszustand rotiert, wenn er bezüglich des Stators in einer zentrierten und unverkippten Position ist. Jeder Spulenkern umfasst zusätzlich zu dem Längsschenkel einen Querschenkel, welcher jeweils an dem zweiten Ende des Längsschenkels angeordnet ist, und welcher sich in radialer Richtung - üblicherweise nach innen - erstreckt, wobei die radiale Richtung senkrecht zur axialen Richtung ist. Der Querschenkel erstreckt ich also im Wesentlichen rechtwinklig zum Längsschenkel. Die Spulenkerne haben jeweils die Form eines L, wobei die Querschenkel die kurzen Schenkel des L bilden. Der zu lagernde Rotor ist dann zwischen den Querschenkeln angeordnet.

Die Mehrzahl der Längsschenkel, die sich in axialer Richtung erstrecken und an die Säulen eines Tempels erinnern, hat dieser Bauweise ihren Namen gegeben.

In einer Ausführungsform hat der Stator der Magnetlagervorrichtung beispielsweise sechs Spulenkerne, die kreisförmig und äquidistant um eine becherförmige Ausnehmung herum angeordnet sind, in welche der Rotor eingesetzt werden kann. Die ersten Enden der Längsschenkel sind üblicherweise in Umfangsichtung durch einen Rückschluss verbunden, welcher der magnetischen Flussführung dient. Der zu lagernde Rotor umfasst einen magnetisch wirksamen Kern, beispielsweise eine permanentmagnetische Scheibe oder einen permanentmagnetischen Ring, der zwischen den radial innenliegenden Enden der Querschenkel angeordnet ist und im Betriebszustand um die axiale Richtung rotiert, wobei der Rotor berührungslos magnetisch bezüglich des Stators gelagert ist.

Für solche Magnetlagervorrichtungen ist es nicht notwendiger Weise so, dass der magnetisch wirksame Kern des Rotors permanentmagnetisch ausgestaltet sein muss. Es sind auch solche Ausgestaltungen bekannt, bei denen der magnetisch wirksame Kern des Rotors permanentmagnetfrei, also ohne Permanentmagnete ausgestaltet ist. Der magnetisch wirksame Kern des Rotors ist dann beispielsweise ferromagnetisch ausgestaltet und besteht beispielsweise aus Eisen, Nickel-Eisen, Kobalt-Eisen, Silizium-Eisen, Mu-Metall oder einem anderen ferromagnetischen Werkstoff.

Ferner sind Ausgestaltungen möglich, bei denen der magnetisch wirksame Kern des Rotors sowohl ferromagnetische Materialien als auch permanentmagnetische Materialien umfasst. Beispielsweise können Permanentmagnete in einen ferromagnetischen Grundkörper eingelegt bzw. eingesetzt werden. Solche Ausgestaltungen sind z.B. vorteilhaft, wenn man bei grossen Rotoren die Kosten durch Einsparen von permanentmagnetischem Material reduzieren will.

Um die für die berührungslos magnetische Lagerung des Rotors notwendigen elektromagnetischen Felder zu erzeugen, tragen die Längsschenkel Wicklungen. Die Wicklungen sind beispielsweise so ausgestaltet, dass um jeden Längsschenkel herum eine konzentrierte Wicklung gewickelt ist, das heisst, die Spulenachse jeder konzentrierten Wicklung erstreckt sich jeweils in axialer Richtung. Dabei ist es typisch für die Tempelbauweise, dass die Spulenachsen der konzentrierten Wicklungen in der axialen Richtung verlaufen und, dass die konzentrierten Wicklungen nicht in der radialen Ebene angeordnet sind, in welcher der Rotor bzw. der magnetisch wirksame Kern des Rotors im Betriebszustand gelagert wird.

Es sind Ausgestaltungen möglich, bei denen auf jedem Längsschenkel genau eine konzentrierte Wicklung angeordnet ist. In anderen Ausgestaltungen sind auf jedem Längsschenkel mehrere, beispielsweise genau zwei konzentrierte Wicklungen vorgesehen. Auch sind Ausgestaltungen möglich, bei denen Wicklungen vorgesehen sind, die um zwei in Umfangsrichtung benachbarte Längsschenkel herum gewickelt sind, sodass sich diese beiden benachbarten Längsschenkel beide im Innenraum der konzentrierten Wicklung befinden. Üblicherweise umfasst die Magnetlagervorrichtung eine Kontrolleinheit, welche die Leistungselektronik für die Ansteuerung und die Versorgung der Wicklungen des Stators umfasst, wie zum Beispiel Stromrichter oder Umrichter zur Bereitstellung des in die Wicklungen einzuprägenden Stroms oder Leistungsschalter, mit denen die Wicklungen angesteuert werden. Im Hinblick auf eine möglichst kompakte Ausgestaltung und eine möglichst geringe Komplexität der Magnetlagervorrichtung sind auch schon Versuche gemacht worden, die Kontrolleinheit möglichst nahe an dem Stator anzuordnen. Hierbei ergeben sich aber erhebliche thermische Probleme, weil insbesondere auch von der Kontrolleinheit im Betriebszustand grosse Wärmemengen produziert werden, die schwierig abzuführen sind.

In der Kontrolleinheit ist es insbesondere die Leistungselektronik, beispielsweise die Leistungsschalter zur Ansteuerung der Wicklungen, welche im Betrieb in erheblichem Umfang Wärme generiert. Sind daher die Motoreinheit und die Kontrolleinheit räumlich nahe beieinander angeordnet, so besteht die Gefahr, dass die im Betrieb generierte Wärme nicht ausreichend gut abgeführt werden kann, was insbesondere zur Überhitzung der elektronischen Komponenten führen kann, wodurch deren Lebensdauer deutlich reduziert wird.

Eine gattungsgemäße Magnetlagervorrichtung wird in der EP 4 084 304 A1 offenbart.

Ausgehend von diesem Stand der Technik ist es daher eine Aufgabe der Erfindung, eine Magnetlagervorrichtung zur berührungslos magnetischen Lagerung eines Rotors mit einem ring- oder scheibenförmigen magnetisch wirksamen Kern vorzuschlagen, welche eine besonders kompakte Ausgestaltung aufweist, wobei die Kontrolleinheit zuverlässig gegen eine Überhitzung geschützt ist.

Der diese Aufgabe lösende Gegenstand der Erfindung ist durch die Merkmale des unabhängigen Patentanspruchs gekennzeichnet.

Erfindungsgemäss wird also ein Magnetlagervorrichtung vorgeschlagen zur berührungslos magnetischen Lagerung eines Rotors, der einen scheibenförmigen oder ringförmigen magnetisch wirksamen Kern umfasst, wobei die Magnetlagervorrichtung ein Gehäuse, einen Stator und eine Kontrolleinrichtung umfasst. Der Stator umfasst eine Mehrzahl von Spulenkernen, von denen jeder einen Längsschenkel aufweist, welcher sich von einem ersten Ende in einer axialen Richtung bis zu einem zweiten Ende erstreckt, sowie einen Querschenkel, welcher an dem zweiten Ende des Längsschenkels angeordnet ist, und sich in einer radialen Richtung erstreckt, die senkrecht zur axialen Richtung ist, wobei an jedem Längsschenkel mindestens eine konzentrierte Wicklung vorgesehen ist, welche den jeweiligen Längsschenkel umgibt, wobei der Stator ferner eine becherförmige Ausnehmung aufweist, in welche der Rotor einsetzbar ist, wobei die becherförmige Ausnehmung an einem axialen Ende des Stators angeordnet ist. Die Kontrolleinheit umfasst eine Platine mit einer Vorderseite und einer Rückseite, wobei auf der Vorderseite Leistungsschalter zur Ansteuerung der Wicklungen angeordnet sind. Das Gehäuse umfasst eine äussere Wandung, ein Statorgehäuse zum Aufnehmen des Stators, ein Kontrollgehäuse zum Aufnehmen der Kontrolleinheit, sowie eine Trennwand, welche das Statorgehäuse vom Kontrollgehäuse trennt. Auf der Trennwand und benachbart zu der äusseren Wandung ist mindestens ein Steg angeordnet, welcher in das Kontrollgehäuse ragt, wobei sich die Rückseite der Platine auf dem Steg abstützt, wobei eine Mehrzahl der Leistungsschalter in dem Bereich der Platine angeordnet ist, mit welchem sich die Rückseite der Platine auf dem Steg abstützt, und wobei zwischen der Mehrzahl von Leistungsschaltern und dem Steg thermische Verbindungselemente zum Abführen von Wärme vorgesehen sind.

Durch diese spezielle Anordnung der Leistungsschalter in Kombination mit den thermischen Verbindungselementen ist es in besonders effizienter Weise möglich, die von den Leistungsschaltern generierte Wärme über die thermischen Verbindungen und den mindestens einen Steg sowie die Trennwand in die äussere Wandung des Gehäuses abzuleiten, von wo die Wärme dann, beispielsweise über Konvektion, an die Umgebung abgegeben wird. Durch diese effiziente Wärmeabfuhr der von den Leistungsschaltern generierten Wärme werden die elektronischen Komponenten der Kontrolleinheit zuverlässig gegen Überhitzung geschützt. Da die Leistungsschalter für die Ansteuerung der Wicklungen üblicherweise eine, wenn nicht die Hauptwärmequelle in der Kontrolleinheit darstellen, ist die zuverlässige Ableitung der von den Leistungsschaltern generierten Wärme ein wesentlicher Aspekt für die Langlebigkeit und die Betriebssicherheit der Magnetlagervorrichtung.

Da die Kontrolleinheit und der Stator beide in dem Gehäuse der Magnetlagervorrichtung angeordnet sind, zeichnet sich die erfindungsgemässe Magnetlagervorrichtung durch eine sehr kompakte und platzsparende Ausgestaltung aus.

Die thermischen Verbindungselemente sind besonders bevorzugt als Durchkontaktierungen ausgestaltet, die auch als thermische Vias bezeichnet werden. Als thermischen Via bezeichnet man üblicherweise eine Bohrung, welche sich von der Vorderseite der Platine durch die Platine hindurch bis zur Rückseite der Platine erstreckt. Über die thermischen Vias kann die von den auf der Vorderseite der Platine angeordneten elektronischen Komponenten generierte Wärme auf die Rückseite der Platine abgeführt werden, wo sie dann von einer Wärmesenke aufgenommen wird.

Die Leistungsschalter sind diejenigen elektronischen Komponenten, mit welchen die Wicklungen des Stators angesteuert und mit Energie versorgt werden. Die Leistungsschalter umfassen typischerweise Transistoren, vorzugsweise MOSFETs, mit denen Halbbrücken oder Vollbrücken realisiert werden, welche die Wicklungen des Stators ansteuern. Typischerweise sind eine oder mehrere solcher Halbbrücken- oder Vollbrückenschaltungen in einem Chip-Gehäuse des Leistungsschalters angeordnet, wobei optional auch Treiber in dem Chip-Gehäuse vorgesehen sein können. Das Chip-Gehäuse des Leistungsschalters wird dann mittels eines sogenannten Die Attach Paddle (DAP) auf der Vorderseite der Platine befestigt. An dem Chip-Gehäuse des Leistungsschalters sind mehrere Anschlusspins vorgesehen, über welche die elektronischen Komponenten des Leistungsschalters, also beispielsweise die Transistoren, elektrisch mit Leiterbahnen oder elektrischen Anschlüssen auf der Platine, verbunden werden können. Die Chip-Gehäuse werden beispielsweise mittels Klebstoffs oder mittels einer Lötverbindung auf der Platine befestigt.

**In** einer bevorzugten Ausgestaltung der Magnetlagervorrichtung sind die äussere Wandung des Gehäuses, die Trennwand und der Steg als einstückige Einheit ausgestaltet sind. Dies ermöglicht eine besonders kompakte Ausgestaltung und eine effiziente Wärmeableitung über das Gehäuse.

Vorzugsweise ist jeder Leistungsschalter auf einer jeweils separaten Montagefläche angeordnet, wobei jede Montagefläche über eine Mehrzahl der thermischen Verbindungselemente mit der Rückseite der Platine verbunden ist, und wobei sich jedes thermische Verbindungselement von der Vorderseite bis zur Rückseite der Platine erstreckt. Diese Montageflächen auf der Vorderseite der Platine sind vorzugsweise als Kühlflächen, insbesondere als metallische Kühlflächen ausgestaltet, von denen jede vorzugsweise über eine Mehrzahl von thermischen Vias thermisch mit der Rückseite der Platine verbunden ist.

Eine bevorzugte Massnahme besteht darin, dass zusätzliche thermische Verbindungselemente vorgesehen sind, von denen sich jedes von der Vorderseite bis zur Rückseite der Platine erstreckt, wobei jedes zusätzliche thermische Verbindungselement ausserhalb der separaten Montageflächen angeordnet ist. Die thermischen Verbindungselemente umfassen also auch solche, die nicht unter den Montageflächen für die Leistungsschalter angeordnet sind, sondern in anderen Bereichen der Platine. Damit kann auch aus solchen Bereichen der Vorderseite der Platine gezielt Wärme abgeführt werden, in denen keine Leistungsschalter angeordnet sind.

Eine weitere bevorzugte Massnahme besteht darin, dass für jede Montagefläche jeweils auf der Rückseite der Platine ein Kontaktpad vorgesehen ist, welches alle thermischen Verbindungselemente thermisch miteinander koppelt, die zu dieser Montagefläche gehören. Das bedeutet, dass jeweils alle thermischen Verbindungselemente, die zu derselben Montagefläche gehören, auf der Rückseite der Platine auf dem Kontaktpad enden, welches somit alle diese thermischen Verbindungselemente auf der Rückseite der Platine thermisch miteinander koppelt. Mittels dieser Kontaktpads lässt sich die thermische Anbindung an das Gehäuse der Magnetlagervorrichtung noch weiter verbessern, weil durch die Kontaktpads die Wärme grossflächig an das Gehäuse übertragen wird.

Ferner ist es eine bevorzugte Massnahme, dass zwischen dem Steg und der Rückseite der Platine eine Wärmeleitschicht angeordnet ist, mit welcher Wärme von der Platine auf das Gehäuse übertragbar ist.

Die Wärmeleitschicht ist vorzugsweise als Folie ausgestaltet, welche auf der Rückseite der Platine befestigt ist. Die Folie besteht aus einem thermisch leitfähigen Material. Diese Folie kann auf die Rückseite der Platine montiert oder gelötet werden. Die Wärmeleitschicht ist in der Lage, die Wärme breitflächig auf das Gehäuse zu übertragen und so den thermischen Übergangswiderstand zu verringern.

Jede als Folie ausgestaltete Wärmeleitschicht ist vorzugsweise aus einem thermisch gut leitfähigen sowie leicht verformbaren, insbesondere duktilen Material, so dass die Folien auch kleine Unebenheiten und mechanische Toleranzen ausgleichen können.

Besonders bevorzugt besteht die Wärmeleitschicht aus einem metallischen Material, beispielsweise aus Kupfer oder aus Silber. Jede Wärmeleitschicht ist beispielsweise als Kupferfolie ausgestaltet. Kupferfolien haben den Vorteil, dass sie sich gut löten lassen. Um die Lötbarkeit weiter zu verbessern, können die Kupferfolien auch mit einem Edelmetall (beispielsweise mit Gold) beschichtet werden.

Eine weitere Möglichkeit besteht darin für die Wärmeleitschicht einen Lack zu verwenden. Dabei sind solche Lacke bevorzugt, welche einen hohen Anteil von Metallpartikeln enthalten. Diese Lacke werden dann auf die Kontaktflächen aufgetragen, um die Wärmeleitschicht zu generieren. Die so entstehende Wärmeleitschicht ist ebenfalls relativ leicht verformbar und ermöglicht auch eine sehr gute thermische Anbindung.

Gemäss einer bevorzugten Ausgestaltung ist das Kontrollgehäuse des Gehäuses mit einem Innenraum ausgestaltet ist, der eine im Wesentlichen rechteckige oder quadratische Querschnittsfläche senkrecht zur axialen Richtung hat. Dies ist bevorzugt, weil das Kontrollgehäuse dadurch besonders gut geeignet ist, um die vorzugsweise rechteckig oder quadratisch ausgestaltete Platine der Kontrolleinrichtung aufzunehmen. Eine rechteckige oder quadratische Ausgestaltung der Platine ist insbesondere bezüglich der Herstellung wesentlich einfacher als beispielsweise eine runde Ausgestaltung.

Ferner ist es bevorzugt, dass das Statorgehäuse des Gehäuses mit einem Innenraum ausgestaltet ist, der eine im Wesentlichen runde Querschnittsfläche senkrecht zur axialen Richtung A hat. Dies ist bevorzugt, weil das Statorgehäuse dadurch besonders gut geeignet ist, die vorzugsweise auf einer Kreislinie angeordneten Spulenkernen des Stators aufzunehmen.

**In** einer bevorzugten Ausgestaltung ist an einem axialen Ende der Magnetlagervorrichtung ein Gehäusedeckel angeordnet, welcher das Kontrollgehäuse verschliesst. Besonders bevorzugt ist der Gehäusedeckel zum hermetischen Verschliessen des Kontrollgehäuses ausgestaltet.

Ferner ist es bevorzugt, dass der Stator einen Spalttopf umfasst, welcher ein axiales Ende des Stators bildet, wobei der Spalttopf die becherförmige Ausnehmung aufweist. **In** die becherförmige Ausnehmung des Spalttopfes kann dann der zu lagernde Rotor eingesetzt werden.

Vorzugsweise umfasst die Trennwand einen Innenbecher, der im Wesentlichen zylindrisch ausgestaltet ist, und der radial innenliegend bezüglich der Wicklungen in dem von den Wicklungen umgebenen Innenraum angeordnet ist. Der Innenbecher ist vorteilhaft, um im Betriebszustand die im Stator generierte Wärme besser abzuführen, z. B. die durch Kupferverluste und Eisenverluste generierte Wärme.

Das Gehäuse umfasst das Statorgehäuse und das Kontrollgehäuse, welche bevorzugt bezüglich der axialen Richtung benachbart zueinander angeordnet sind, wobei das Statorgehäuse zur Aufnahme der Spulenkerne mit den darauf angeordneten konzentrierten Wicklungen ausgestaltet ist, und das Kontrollgehäuse zur Aufnahme der Kontrolleinheit für die Ansteuerung und die Versorgung der Wicklungen mit elektrischer Energie zur Erzeugung elektromagnetischer Felder.

Vorzugsweise ist das Gehäuse derart ausgestaltet, dass die Spulenkerne mit den darauf angeordneten konzentrierten Wicklungen in einer ersten Einbaurichtung in axialer Richtung in das Statorgehäuse einführbar sind, und die Kontrolleinheit in einer zweiten Einbaurichtung in das Kontrollgehäuse einführbar ist, wobei die erste Einbaurichtung entgegengesetzt zur zweite Einbaurichtung gerichtet ist. Dabei hat das Gehäuse vorzugsweise zwei voneinander getrennte Bereiche, von denen einer das Statorgehäuse bildet und der andere das Kontrollgehäuse. Diese beiden Bereiche sind durch die Trennwand voneinander getrennt. Die Trennwand hat Durchlässe, z.B. für elektrische Verbindungen. Das Gehäuse ist bezüglich der Umfangsrichtung vorzugsweise einstückig ausgestaltet.

Gemäss einer besonders bevorzugten Ausführungsform ist der Stator zur Erzeugung eines Drehmoments ausgestaltet, mit welchem der Rotor berührungslos magnetisch zur Rotation um die axiale Richtung antreibbar ist.

Weitere vorteilhafte Massnahmen und Ausgestaltungen der Erfindung ergeben sich aus den abhängigen Ansprüchen.

Im Folgenden wird die Erfindung anhand von Ausführungsbeispielen und anhand der Zeichnung näher erläutert. In der Zeichnung zeigen:
- Fig. 1:: eine Schnittdarstellung eines Ausführungsbeispiels einer erfindungsgemässen Magnetlagervorrichtung,
- Fig. 2:: eine perspektivische Darstellung des Ausführungsbeispiels aus Fig. 1 in einer Explosionsdarstellung,
- Fig. 3: eine perspektivische Darstellung des Stators und der Halteeinrichtung,
- Fig. 4:: eine perspektivische Explosionsdarstellung der Spulenkerne, der Wicklungen und der Halteeinrichtung,
- Fig. 5:: eine Schnittdarstellung des Spalttopfes des Stators,
- Fig. 6:: eine perspektivische Darstellung des Kontrollgehäuses und der Platine der Kontrolleinrichtung,
- Fig. 7:: eine schematische Darstellung von thermischen Verbindungselementen,
- Fig. 8:: eine Aufsicht auf das Kontrollgehäuse,
- Fig. 9:: eine Aufsicht auf die Rückseite eines Ausführungsbeispiels einer Platine,
- Fig. 10:: eine Aufsicht auf die Vorderseite eines Ausführungsbeispiels einer Platine,
- Fig. 11:: eine Aufsicht auf die Rückseite einer Variante für die Platine,
- Fig. 12:: eine schematische Schnittdarstellung der Platine aus Fig. 11, und
- Fig. 13:: eine perspektivische Darstellung einer Wärmeleitschicht.

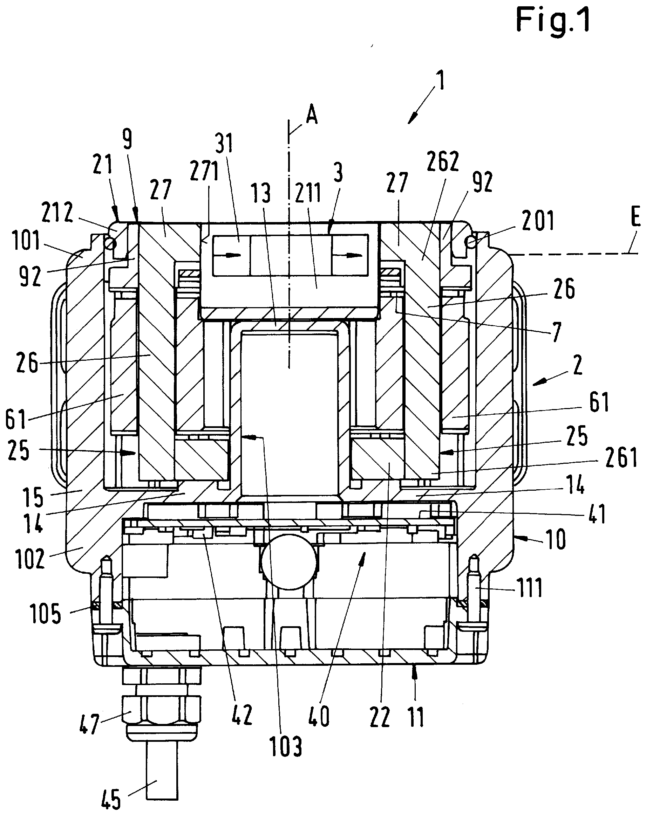

Fig. 1 zeigt eine Schnittdarstellung eines Ausführungsbeispiels einer erfindungsgemässen Magnetlagervorrichtung, die gesamthaft mit dem Bezugszeichen 1 bezeichnet ist. Die Magnetlagervorrichtung 1 ist für die berührungslos magnetische Lagerung eines Rotors 3 ausgestaltet, der einen scheibenförmigen oder ringförmigen magnetisch wirksamen Kern 31 umfasst.

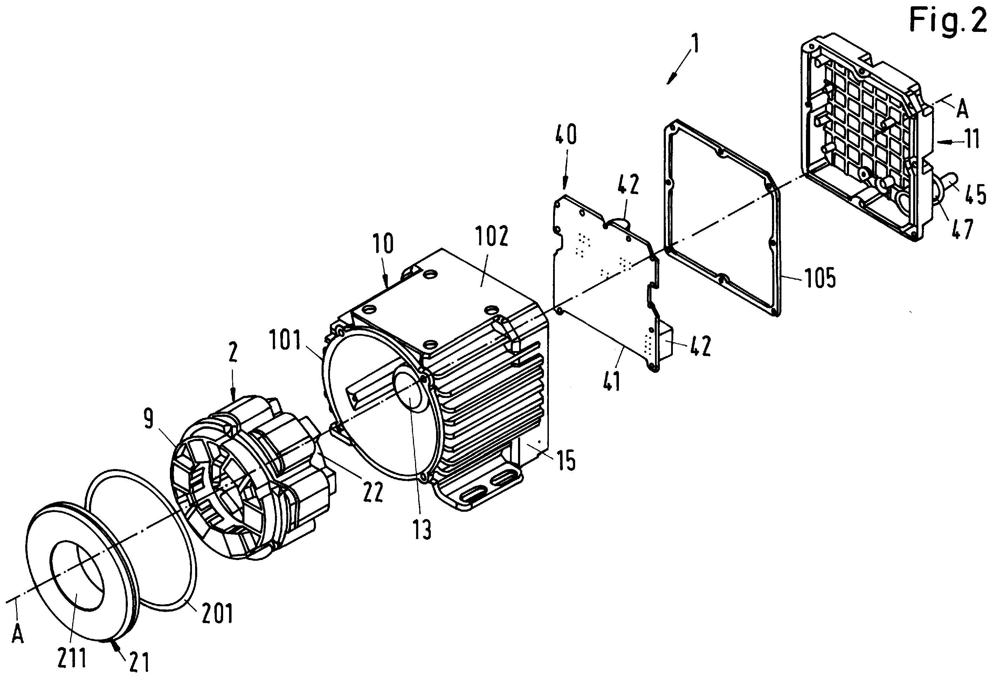

Zum besseren Verständnis zeigt Fig. 2 noch eine perspektivische Darstellung des Ausführungsbeispiels aus Fig. 1 in einer perspektivischen Explosionsdarstellung, wobei in Fig. 2 der Rotor 3 nicht dargestellt ist. Die Magnetlagervorrichtung 1 ist gemäss der Tempelbauweise ausgestaltet und umfasst einen Stator 2, welcher eine Mehrzahl von Spulenkernen 25 - hier sechs Spulenkerne 25 - aufweist, von denen jeder einen Längsschenkel 26 umfasst, welcher sich von einem ersten Ende 261 in einer axialer Richtung A bis zu einem zweiten Ende 262 erstreckt, sowie einen senkrecht zum Längsschenkel 26 angeordneten Querschenkel 27, welcher sich in einer radialen Richtung erstreckt, die senkrecht zu der axialen Richtung A ist. Jeder Querschenkel 27 wird bezüglich der radialen Richtung durch eine Stirnfläche 271 begrenzt, welche den Pol des zugehörigen Spulenkerns 25 bildet.

An jedem Längsschenkel 26 ist jeweils mindestens eine, bei diesem Ausführungsbeispiel genau eine, konzentrierte Wicklung 61 vorgesehen, welche den jeweiligen Längsschenkel 26 umschliesst.

Die Magnetlagervorrichtung 1 umfasst ein Gehäuse 10, in welchem die Spulenkerne 25 angeordnet sind.

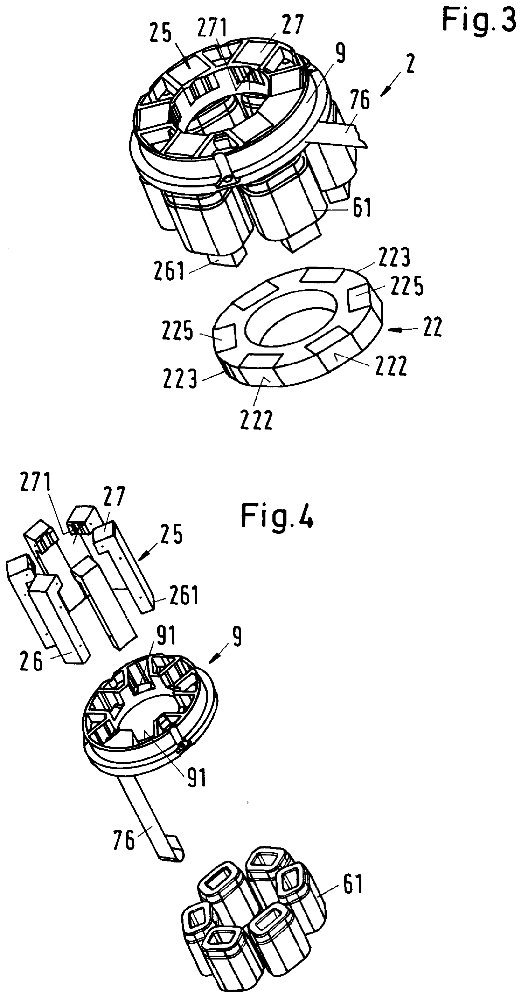

Zum besseren Verständnis zeigen die Fig. 3 und Fig. 4 weitere Darstellungen des Stators 2 des Ausführungsbeispiels der Magnetlagervorrichtung 1, wobei das Gehäuse 10 nicht dargestellt ist. Fig. 3 zeigt eine perspektivische Darstellung des Stators 2 und einer Halteeinrichtung 9 für die Spulenkerne 25. Ferner ist in Fig. 3 ein Rückschluss 22 dargestellt, welcher alle ersten Enden 261 der Längsschenkel 26 - also die darstellungsgemäss (Fig. 1) unteren Enden 261 - miteinander verbindet und der Führung des magnetischen Flusses dient. Der Rückschluss 22 ist vorzugsweise ringförmig ausgestaltet. Fig. 4 zeigt eine perspektivische Explosionsdarstellung der Spulenkerne 25 mit den darauf angeordneten konzentrierten Wicklungen 61 und der Halteeinrichtung 9.

Das Gehäuse 10 ist vorzugsweise aus einem metallischen Material gefertigt, beispielsweise aus Aluminium oder rostfreiem Stahl. Zur besseren chemischen Resistenz kann das Gehäuse 10 mit einer Beschichtung versehen sein, vorzugsweise mit einer Kunststoffbeschichtung aus einem chemisch hoch resistenten Kunststoff. Beispiele für solche Kunststoffe sind PTFE (Polytetrafluorethylen), PFA (Perfluoralkoxy-Polymere), ECTFE (Ethylenchlortrifluorethylen), ETFE (Ethylen-Tetrafluorethylen), Epoxidharz (Polyepoxid), PPA (Polyphthalamid), PE (Polyethylen). Je nach beabsichtigter Anwendung kann das Gehäuse 10 auch aus Titan oder einem Chromstahl hergestellt sein.

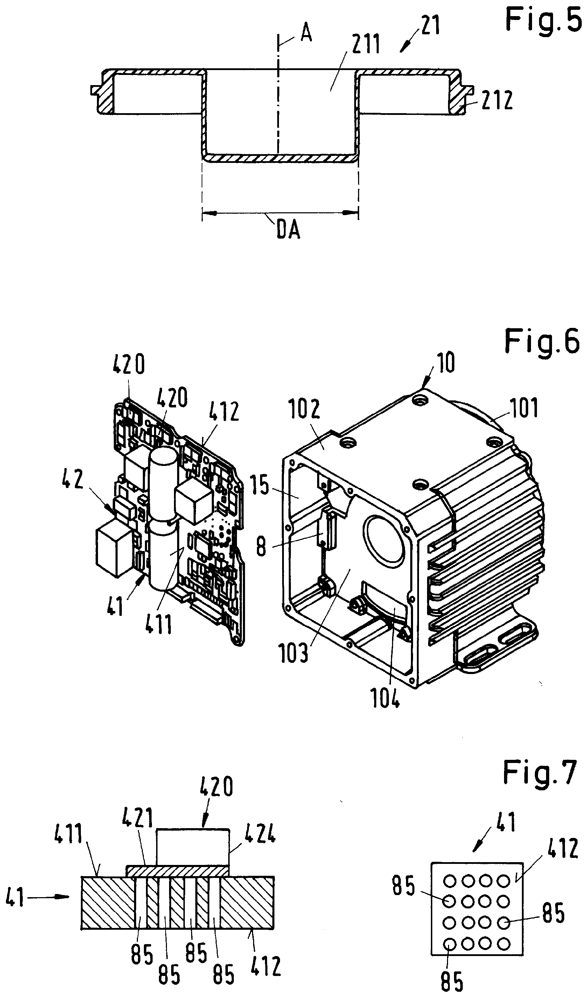

Der Stator 2 umfasst ferner einen Spalttopf 21 mit einer becherförmigen Ausnehmung 211 (siehe auch Fig. 5), in welche der zu lagernde Rotor 3 einsetzbar ist (siehe Fig. 1). Der Spalttopf 21 bildet eines der beiden axialen Enden des Stators 2 bzw. der Magnetlagervorrichtung 1, gemäss der Darstellung in Fig. 1 das obere axiale Ende des Stators 2. An dem anderen axialen Ende der Magnetlagervorrichtung 1 ist ein Gehäusedeckel 11 angeordnet, welcher das Gehäuse 10 verschliesst.

Der Spalttopf 21 ist fest mit dem Gehäuse 10 verbunden, beispielsweise mittels einer formschlüssigen Verbindung und/oder mittels einer elastischen Dichtung 201. Vorzugsweise ist der Spalttopf 21 hermetisch dicht mit dem Gehäuse 10 verbunden. Der Gehäusedeckel 11 ist fest mit dem Gehäuse 10 verbunden, beispielsweise mittels Schrauben 111 (Fig. 1), wobei zwischen dem Gehäusedeckel 11 und dem Gehäuse 10 optional ein Dichtungselement 105 angeordnet ist. Das Dichtungselement 105 kann insbesondere als Flachdichtung ausgestaltet sein. Vorzugsweise ist der Gehäusedeckel 11 hermetisch dicht mit dem Gehäuse 10 verbunden.

Besonders bevorzugt bildet das Gehäuse 10 zusammen mit dem Spalttopf 21 und dem Gehäusedeckel 11 ein hermetisch dichtes Gehäuse, in welchem die anderen Komponenten des Stators 2 hermetisch dicht gekapselt sind. Das Gehäuse 10 ist vorzugsweise mit einer thermisch gut leitenden Vergussmasse, beispielsweise mit einem Epoxidharz, aufgefüllt, sodass die Komponenten, die im Inneren des Gehäuses 10 angeordnet sind, mit der Vergussmasse umgeben sind. Dadurch wird der allgemeine thermische Widerstand reduziert und Vibrationen werden gedämpft.

Der Gehäusedeckel 11 besteht vorzugsweise aus einem Kunststoff. Insbesondere für Anwendungen in chemisch aggressiven Umgebungen ist ein chemisch resistenter Kunststoff wie beispielsweise Polypropylen bevorzugt.

Die Querschenkel 27 der Spulenkerne 25 sind in dem Spalttopf 21 angeordnet, und zwar derart, dass die Stirnflächen 271 der Querschenkel 27 um die becherförmige Ausnehmung 211 herum angeordnet sind.

Die Spulenkerne 25 des Stators 2 sind äquidistant auf einer Kreislinie angeordnet, sodass die Stirnflächen 271 den magnetisch wirksamen Kern 31 des Rotors 3 umgeben, wenn der Rotor 3 in die becherförmige Ausnehmung 211 eingesetzt ist. An jedem Längsschenkel 26 ist jeweils genau eine konzentrierte Wicklungen 61 vorgesehen, welche den Längsschenkel 26 umgibt.

In anderen Ausführungsformen können an den Längsschenkeln 26 auch mehr als eine konzentrierte Wicklung angeordnet sein. Beispielsweise gibt es Ausführungsbeispiele, bei denen an jedem der Längsschenkel 26 jeweils genau zwei konzentrierte Wicklungen vorgesehen sind, von denen jede den jeweiligen Längsschenkel 26 umgibt, wobei die beiden auf dem gleichen Längsschenkel 26 angeordneten Wicklungen bezüglich der axialen Richtung A benachbart zueinander angeordnet sind.

Die konzentrierten Wicklungen 61 dienen dazu, elektromagnetische Felder zu erzeugen, mit welchen der Rotor 3 berührungslos magnetisch in der becherförmigen Ausnehmung 211 des Spalttopfs 21 lagerbar ist.

Ferner ist eine Kontrolleinheit 40 für die Ansteuerung und die Versorgung der Wicklungen 61 mit elektrischer Energie vorgesehen. Die Kontrolleinheit 40 umfasst insbesondere die Leistungselektronik, welche die erforderlichen Ströme in die Wicklungen 61 einspeist. Die Kontrolleinheit 40 ist in Fig. 1 und in Fig. 2 dargestellt. Insbesondere bevorzugt ist die Kontrolleinheit 40 auch innerhalb des Gehäuses 10 angeordnet, beispielsweise darstellungsgemäss (Fig. 1) unterhalb der ersten Enden 261 der Längsschenkel 26 der Spulenkerne 25. Die Kontrolleinheit 40 ist optional auch mit einer thermischen Vergussmasse umgossen oder an das Gehäuse 10 und den Rückschluss 22 und/oder die Spulenkerne 25 des Stators 2 gekoppelt. Die Kontrolleinheit 40 umfasst eine Platine 41, auf welcher verschiedene elektronische Komponenten 42 angeordnet sind.

Wie dies insbesondere in den Fig. 1 und Fig. 2 zu erkennen ist, umfasst das Gehäuse 10 vorzugsweise zwei voneinander getrennte und bezüglich der axialen Richtung A benachbart angeordnete Bereiche, von denen einer ein Statorgehäuse 101 bildet und der andere ein Kontrollgehäuse 102. Das Statorgehäuse 101 des Gehäuses 10 ist für die Aufnahme der Spulenkerne 25 mit den darauf angeordneten Wicklungen 61 ausgestaltet, und das Kontrollgehäuse 102 ist für die Aufnahme der Kontrolleinheit 40 ausgestaltet. Das Statorgehäuse 101 und das Kontrollgehäuse 102 sind durch eine Trennwand 103 voneinander getrennt, wobei in der Trennwand 103 Durchführungen oder Öffnungen 104 (siehe z.B. Fig. 6) vorgesehen sind, durch welche Verbindungsleitungen, beispielsweise elektrische Verbindungen aus dem Kontrollgehäuse 102 in das Statorgehäuse 101 hindurchgeführt werden können.

Entsprechend einer bevorzugten Massnahme umfasst die Trennwand 103 einen Innenbecher 13, der im Wesentlichen zylindrisch ausgestaltet ist, und der radial innenliegend bezüglich der Wicklungen 61 in dem von den Wicklungen 61 umgebenen Innenraum angeordnet ist. Der Innenbecher 13 ist über einen flanschartigen Vorsprung 14 der Trennwand 103 mit einer äusseren Wandung 15 des Gehäuses 10 verbunden. Die äussere Wandung 15 bildet die radial aussenliegende Begrenzung des Gehäuses 10. Besonders bevorzugt ist die Trennwand 103, welche den Innenbecher 13 und den flanschartige Vorsprung 14 umfasst, integraler Bestandteil des Gehäuses 10. Die äussere Wandung 15 und die Trennwand 103 sind in ihrer Gesamtheit einstückig ausgestaltet und bilden das vorzugsweise einstückige Gehäuse 10.

Die Trennwand 103 mit dem Innenbecher 13 und dem flanschartigen Vorsprung 14 trennen den Bereich des Gehäuses 10, welcher das Statorgehäuse 101 bildet, von dem Bereich, welcher das Kontrollgehäuse 102 bildet.

Der mit dem flanschartigen Vorsprung 14 verbundene Innenbecher 13 der Trennwand 103 erstreckt sich von dem radial innenliegenden Rand des flanschartigen Vorsprungs 14 in axialer Richtung A und ist radial innenliegend bezüglich der Wicklungen 61 und des Rückschlusses 22 in dem von den Wicklungen 61 umgegebenen Innenraum angeordnet, wie das insbesondere in Fig. 1 zu erkennen ist. Bezüglich der radialen Richtung ist der Innenbecher 13 benachbart zu den Längsschenkeln 26 der Spulenkerne 25 bzw. den darauf angeordneten Wicklungen 61 angeordnet, sodass der Innenbecher 13 die von den Wicklungen 61 und den Spulenkernen 25 generierte Wärme besonders gut aufnehmen und abführen kann. Bezüglich der axialen Richtung A erstreckt sich der Innenbecher 13 etwa bis an die becherförmige Ausnehmung 211 des Spalttopfes 21.

Wie dies insbesondere in Fig. 2 zu erkennen ist, ist das Statorgehäuse 101 des Gehäuses 10 mit einem Innenraum ausgestaltet, der eine im Wesentlichen kreisförmigen oder ringförmige Querschnittsfläche senkrecht zur axialen Richtung A hat. Dies ist bevorzugt, weil das Statorgehäuse 101 dadurch den ringförmigen Rückschluss 22 mit den um den Rückschluss 22 herum angeordneten Spulenkernen 25 besonders gut aufnehmen kann. Das Kontrollgehäuse 102 des Gehäuses 10 ist mit einem Innenraum ausgestaltet, der eine im Wesentlichen rechteckige oder quadratische Querschnittsfläche senkrecht zur axialen Richtung A hat. Dies ist bevorzugt, weil das Kontrollgehäuse 102 dadurch besonders gut geeignet ist, um die vorzugsweise rechteckig oder quadratisch ausgestaltete Platine 41 der Kontrolleinrichtung 40 aufzunehmen. Eine rechteckige oder quadratische Ausgestaltung der Platine 41 ist insbesondere bezüglich der Herstellung wesentlich einfacher als beispielsweise eine runde Ausgestaltung.

Aufgrund dieser Ausgestaltung des Statorgehäuses 101 und des Kontrollgehäuses 102 hat das axiale Ende des Stators 2, an welchem der Spalttopf 21 das Gehäuse 10 verschliesst, einen im Wesentlichen runden Querschnitt, sodass der Spalttopf 21 eine runde bzw. kreisringförmige Ausgestaltung aufweist. Dagegen hat das axiale Ende des Stators 2, an welchem der Gehäusedeckel 11 das Gehäuse 10 verschliesst, einen im Wesentlichen rechteckigen oder quadratischen Querschnitt, sodass der Gehäusedeckel 11 eine rechteckige oder quadratische Ausgestaltung aufweist.

Mit beispielhaftem Charakter sind in Fig. 1 einige Komponenten der Kontrolleinheit 40 dargestellt. Die Kontrolleinheit 40 umfasst beispielsweise die Platine 41, auf der die Elektronikkomponenten 42 vorgesehen sind, z. B. die Leistungselektronik für die Ansteuerung der Wicklungen 61. Dies wird weiter hinten noch genauer erläutert. Die Platine 41 kann ferner beispielsweise Auswerteelektronik zur Auswertung der Signale von Sensoren, z.B. Magnetfeldsensoren, enthalten und als Kommunikationsinterface dienen. Die Platine 41 ist vorzugsweise als Elektronikprint bzw. PCB (printed circuit board) ausgestaltet. Ferner ist ein Anschlusskabel 45 vorgesehen, das über einen Kabelanschluss (nicht dargestellt) oder einen Stecker mit der Platine 41 verbunden ist. Das Anschlusskabel 45 führt aus dem Gehäuse 10 heraus und dient beispielsweise der Energieversorgung der Magnetlagervorrichtung 1. Das Anschlusskabel 45 wird mittels einer dichtend ausgestalteten Kabeldurchführung 47 aus dem Gehäuse 10 herausgeführt. Vorzugsweise ist die Kabeldurchführung 47 hermetisch dichtend ausgestaltet.

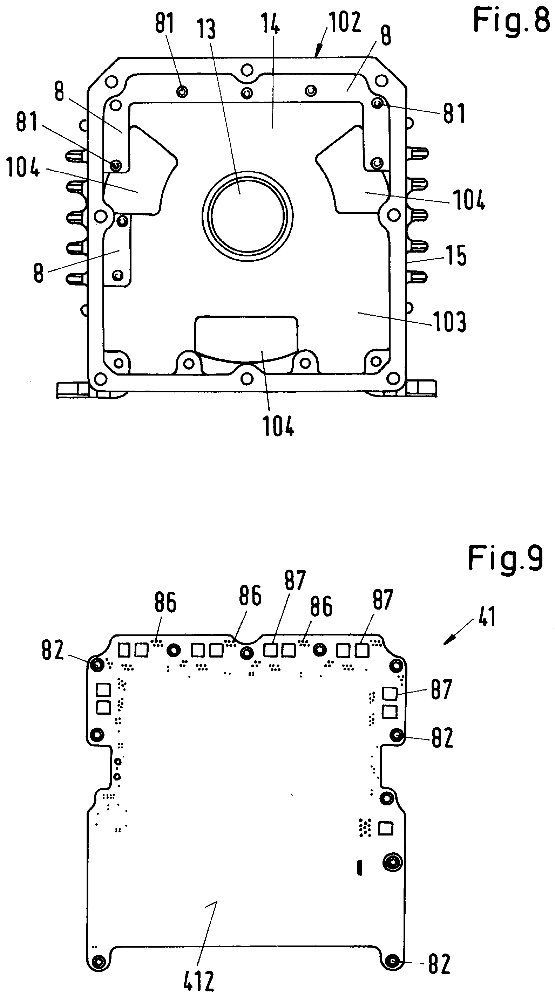

Die Platine 41 der Kontrolleinrichtung 40 ist über Verbindungsleitungen (nicht dargestellt), beispielsweise Kabel, mit den Wicklungen 61 verbunden, um diese anzusteuern und mit Energie zu versorgen. Dazu sind in der Trennwand 103 die Durchführungen oder Öffnungen 104 (Fig. 8) vorgesehen, durch welche die Verbindungsleitungen hindurchgeführt werden. Solche Durchführungen können beispielsweise in dem flanschartigen Vorsprung 14 oder in dem Innenbecher 13 angeordnet sein.

Die Platine 41 ist vorzugsweise auf dem flanschartigen Vorsprung 14 angeordnet, wie weiter hinten noch detaillierter erläutert wird. Hierdurch ist es in besonders effizienter Weise möglich, die in der Kontrolleinheit 40 generierte Wärme über das Gehäuse 10 abzuführen.

Der Innenraum des Innenbechers 13, also der von dem Innenbecher 13 umschlossene Raum, kann für weitere elektronische Komponenten, Elektronikboards oder Stecker oder Verbindungen genutzt werden. Diese sind in Fig. 1 aus Gründen der besseren Übersicht nicht dargestellt.

Gemäss einer speziell bevorzugten Ausgestaltung ist der Stator 2 so ausgestaltet, dass er zusätzlich zur berührungslos magnetischen Lagerung des Rotors 3 auch ein Drehmoment auf den Rotor 3 bzw. den magnetisch wirksamen Kern 31 des Rotors 3 ausüben kann, welches den Rotor 3 zu einer Rotation um eine Solldrehachse antreibt. Die Solldrehachse bezeichnet dabei diejenige Achse, um welche sich der Rotor 3 im Betriebszustand dreht, wenn sich der Rotor 3 bezüglich des Stators 2 in einer zentrierten und unverkippten Lage befindet, so wie dies in Fig. 1 dargestellt ist. Diese Solldrehachse erstreckt sich in der axialen Richtung A, das heisst, bei dieser bevorzugten Ausgestaltung ist der in dem Spalttopf 21 des Stators 2 angeordnete Rotor 3 zur Rotation um die axiale Richtung A antreibbar. Üblicherweise stimmt die Solldrehachse mit der Mittelachse des Stators 2 überein, welche sich in der axialen Richtung A erstreckt.

Bei dieser Ausgestaltung erzeugen die konzentrierten Wicklungen 61 also elektromagnetische Drehfelder, mit denen der Rotor 3 sowohl berührungslos magnetisch bezüglich des Stators 2 lagerbar ist als auch berührungslos zur Rotation um die axiale Richtung A antreibbar ist.

Es versteht sich, dass die Anzahl von sechs Spulenkernen 25 zwar bevorzugt, aber nur beispielhaft zu verstehen ist. Es sind natürlich auch solche Ausgestaltungen möglich, bei denen der Stator 2 weniger als sechs, z. B. fünf oder vier oder drei Spulenkerne 25 aufweist, oder solche Ausgestaltungen, bei denen der Stator 2 mehr als sechs, z. B. sieben oder acht oder neun Spulenkerne 25 aufweist oder eine beliebige grössere Anzahl von Spulenkernen 25.

Der Rotor 3 umfasst den magnetisch wirksamen Kern 31, welcher ring- oder scheibenförmig ausgestaltet ist. Der magnetisch wirksame Kern 31 ist gemäss der Darstellung in Fig. 1 als Ring ausgestaltet und definiert eine magnetische Mittelebene. Alternativ kann der magnetisch wirksame Kern 31 auch als Scheibe ausgestaltet sein. In der Regel ist bei einem scheibenförmigen oder ringförmigen magnetisch wirksamen Kern 31 die magnetische Mittelebene die geometrische Mittelebene des magnetisch wirksamen Kerns 31 des Rotors 3, die senkrecht zur axialen Richtung A liegt. Im Betriebszustand ist der magnetisch wirksame Kern 31 in einer radialen Ebene E gelagert, welche senkrecht auf der axialen Richtung A steht. Die radiale Ebene ist in Fig. 1 durch die Linie E angedeutet, die senkrecht auf der axialen Richtung A steht. Die radiale Ebene E ist also diejenige Ebene, welche senkrecht auf der axialen Richtung A steht und die Linie E enthält.

Die radiale Ebene E ist diejenige Ebene, in welcher der magnetisch wirksame Kern 31 des Rotors 3 im Betriebszustand zwischen den Stirnflächen 271 im Stator 2 aktiv magnetisch gelagert ist. Wenn der Rotor 3 nicht verkippt und in axialer Richtung A nicht ausgelenkt ist, liegt die magnetische Mittelebene in der radialen Ebene E. Die radiale Ebene E definiert die x-y-Ebene eines kartesischen Koordinatensystems, dessen z-Achse in axialer Richtung A verläuft.

Mit der radialen Position des magnetisch wirksamen Kerns 31 bzw. des Rotors 3 wird die Lage des Rotors 3 in der radialen Ebene E bezeichnet.

Da es für das Verständnis der Erfindung ausreichend ist, ist in der Zeichnung in der Fig. 1 von dem Rotor 3 nur der magnetisch wirksame Kern 31 dargestellt. Es versteht sich, dass der Rotor 3 natürlich auch noch weitere Komponenten umfassen kann wie beispielsweise Ummantelungen oder Kapselungen, die vorzugsweise aus einem Kunststoff hergestellt sind, oder aus einem Metall oder aus einer Metalllegierung oder aus einer Keramik bzw. einem keramischen Werkstoff. Ferner kann der Rotor 3 auch Flügel zum Mischen, Rühren oder Pumpen von Fluiden oder sonstige Komponenten umfassen.

Wenn der Rotor 3 in die becherförmige Ausnehmung 211 des Spalttopfes 21 eingesetzt ist, wird der Rotor 3 und insbesondere der magnetisch wirksame Kern 31 des Rotors 3 von den radial aussenliegend angeordneten Stirnflächen 271 der Querschenkeln 27 der Spulenkerne 25 des Stators 2 umgeben. Die Querschenkel 27 bilden somit eine Mehrzahl von ausgeprägten Statorpolen- hier sechs Statorpole. Die Querschenkel 27 sind an den oberen Enden der Längsschenkel 26 und in der radialen Ebene E angeordnet. Jeder Querschenkel 27 erstreckt sich in der radialen Richtung auf den Rotor 3 zu.

Wenn sich der magnetisch wirksame Kern 31 des Rotors 3 während des Betriebs in seiner Soll-Position befindet, so ist der magnetisch wirksame Kern 31 zwischen den Stirnflächen 271 der Querschenkel 27 zentriert, sodass die in der radialen Ebene E angeordneten Querschenkel 27 auch in der magnetischen Mittelebene liegen. Die konzentrierten Wicklungen 61 sind darstellungsgemäss unterhalb der radialen Ebene E angeordnet und so ausgerichtet, dass ihre Spulenachsen in axialer Richtung A verlaufen.

Alle ersten Enden 261 der Längsschenkel 26 - also die darstellungsgemäss (Fig. 1) unteren Enden 261 - sind durch den Rückschluss 22 (siehe auch Fig. 3) miteinander verbunden. Der Rückschluss 22 ist vorzugsweise ringförmig ausgestaltet. Dabei sind solche Ausgestaltungen möglich (siehe z. B. Fig. 1), bei welchen sich der Rückschluss 22 radial innenliegend entlang aller ersten Enden 261 der Längsschenkel 26 erstreckt.

Um die für die magnetische Lagerung des Rotors 3 und optional zur Erzeugung eines Drehmoments auf den Rotor 3 notwendigen elektromagnetischen Felder zu erzeugen, tragen die Längsschenkel 26 der Spulenkerne 25 die als konzentrierte Wicklungen 61 ausgestalteten Wicklungen.

Mit diesen konzentrierten Wicklungen 61 werden im Betriebszustand diejenigen elektromagnetischen Drehfelder erzeugt, mit welchen eine beliebig einstellbare Querkraft in radialer Richtung auf den Rotor 3 ausübbar ist, sodass die radiale Position des Rotors 3, also seine Position in der zur axialen Richtung A senkrechten radialen Ebene **E,** aktiv steuerbar bzw. regelbar ist. Optional wird mit diesen elektromagnetischen Drehfeldern zusätzlich ein Drehmoment auf den Rotor 3 bewirkt.

Mit dem "magnetisch wirksamen Kern 31" des Rotors 3 ist derjenige Bereich des Rotors 3 gemeint, welcher für die Erzeugung der magnetischen Lagerkräfte und optional für die Drehmomentbildung magnetisch mit dem Stator 2 zusammenwirkt.

Wie bereits erwähnt, ist der magnetisch wirksame Kern 31 bei diesem Ausführungsbeispiel ringförmig ausgestaltet. Ferner ist der magnetisch wirksame Kern 31 permanentmagnetisch ausgestaltet. Dazu kann der magnetisch wirksame Kern 31 mindestens einen Permanentmagneten, aber auch mehrere Permanentmagnete umfassen oder - wie im hier beschriebenen Ausführungsbeispiel - vollständig aus einem permanentmagnetischen Material bestehen, sodass der magnetisch wirksame Kern 31 der Permanentmagnet ist. Der magnetisch wirksame Kern 31 ist beispielsweise in radialer Richtung magnetisiert.

Es sind auch solche Ausgestaltungen möglich, bei denen der magnetisch wirksame Kern 31 permanentmagnetfrei, also ohne Permanentmagnete ausgestaltet ist. Der Rotor 3 ist dann z.B. als Reluktanzläufer ausgestaltet. Der magnetisch wirksame Kern 31 des Rotors 3 besteht dann beispielsweise aus einem weichmagnetischen Material. Geeignete weichmagnetische Materialien für den magnetisch wirksamen Kern 31 sind beispielsweise ferromagnetische oder ferrimagnetische Materialien, also insbesondere Eisen, Nickel-Eisen, Kobalt-Eisen, Silizium-Eisen, Mu-Metall.

Ferner sind Ausgestaltungen möglich, bei denen der magnetisch wirksame Kern 31 des Rotors 3 sowohl ferromagnetische Materialien als auch permanentmagnetische Materialien umfasst. Beispielsweise können Permanentmagnete in einen ferromagnetischen Grundkörper eingelegt bzw. eingesetzt werden. Solche Ausgestaltungen sind z.B. vorteilhaft, wenn man bei grossen Rotoren die Kosten durch Einsparen von permanentmagnetischem Material reduzieren will.

Auch sind Ausgestaltungen möglich, bei denen der Rotor nach dem Prinzip eines Käfigläufers ausgestaltet ist.

Sowohl der ringförmige Rückschluss 22 als auch die Spulenkerne 25 des Stators 2 sind jeweils aus einem weichmagnetischen Material gefertigt, weil sie als Flussleitelemente zur Führung des magnetischen Flusses dienen.

Geeignete weichmagnetische Materialien für die Spulenkerne 25 und den Rückschluss 22 sind beispielsweise ferromagnetische oder ferrimagnetische Materialien, also insbesondere Eisen, Nickel-Eisen, Kobalt-Eisen Silizium-Eisen oder Mu-Metall. Hierbei ist für den Stator 2 eine Ausgestaltung als Statorblechpaket bevorzugt, bei welcher die Spulenkerne 25 und der Rückschluss 22, geblecht ausgestaltet sind, das heisst sie bestehen aus mehreren dünnen Blechelementen, die gestapelt sind.

Ferner ist es möglich, dass die Spulenkerne 25 und der Rückschluss 22 aus gepressten und anschliessend gesinterten Körnern der genannten Materialien bestehen. Die metallischen Körner sind dabei vorzugsweise in eine Kunststoffmatrix eingebettet, sodass sie zumindest teilweise gegeneinander isoliert sind, wodurch sich Wirbelstromverluste minimieren lassen. Es sind also für den Stator auch weichmagnetische Verbundwerkstoffe geeignet, welche aus elektrisch isolierten und zusammengepressten Metallpartikeln bestehen. Insbesondere können diese weichmagnetischen Verbundwerkstoffe, die auch als SMC (Soft Magnetic Composites) bezeichnet werden, aus Eisenpulverpartikeln bestehen, die mit einer elektrisch isolierenden Schicht beschichtet sind. Diese SMC werden dann mittels pulvermetallurgischer Verfahren zu der gewünschten Ausgestaltung geformt.

Während des Betriebs der Magnetlagervorrichtung 1 wirkt der magnetisch wirksame Kern 31 des Rotors 3 mit dem Stator 2 zusammen, derart, dass der Rotor 3 berührungslos magnetisch bezüglich des Stators 2 lagerbar ist, und vorzugsweise zusätzlich berührungslos magnetisch in Rotation um die axiale Richtung A versetzt werden kann. Dabei ist es besonders vorteilhaft, dass dieselben Wicklungen 61 mit denen die magnetische Lagerung des Rotors 3 bewirkt wird, auch zur Erzeugung eines Drehmoments auf den Rotor 3 dienen. Vorzugsweise sind dann drei Freiheitsgrade des Rotors 3, nämlich seine Position in der radialen Ebene E und seine Rotation, aktiv regelbar. Bezüglich seiner axialen Auslenkung aus der radialen Ebene E in axialer Richtung A ist der magnetisch wirksame Kern 31 des Rotors 3 passiv magnetisch, das heisst nicht ansteuerbar, durch Reluktanzkräfte stabilisiert. Auch bezüglich der verbleibenden zwei Freiheitsgrade, nämlich Verkippungen bezüglich der zur Solldrehachse senkrechten radialen Ebene E ist der magnetisch wirksame Kern 31 des Rotors 3 ebenfalls passiv magnetisch stabilisiert. Der Rotor 3 ist also durch das Zusammenwirken des magnetisch wirksamen Kerns 31 mit den Spulenkernen 25 in axialer Richtung A sowie gegen Verkippungen (insgesamt drei Freiheitsgrade) passiv magnetisch gelagert oder passiv magnetisch stabilisiert und in der radialen Ebene (zwei Freiheitsgrade) aktiv magnetisch gelagert.

Wie dies allgemein üblich ist, bezeichnet auch im Rahmen dieser Anmeldung eine aktive magnetische Lagerung eine solche, die aktiv steuer- bzw. regelbar ist, beispielsweise über die mit den konzentrierten Wicklungen 61 generierten elektromagnetischen Felder. Eine passive magnetische Lagerung oder eine passive magnetische Stabilisierung bezeichnet eine solche, die nicht ansteuerbar bzw. regelbar ist. Die passive magnetische Lagerung oder Stabilisierung basiert beispielsweise auf Reluktanzkräften, welche den Rotor 3 bei einer Auslenkung aus seiner Soll-Position, also z. B. bei einer Verschiebung oder Auslenkung in axialer Richtung A oder bei einer Verkippung, wieder in seine Soll-Position bringen.

Bei der Magnetlagervorrichtung 1 wird im Unterschied zu klassischen Magnetlagern die magnetische Lagerung - und optional die Generierung eines auf den Rotor wirkenden Drehmoments - über elektromagnetische Drehfelder realisiert. Zur kombinierten Erzeugung der magnetischen Lagerkräfte und eines Drehmoments zum Rotieren des Rotors 3 um die axiale Richtung A ist es einerseits möglich - wie in Fig 1 gezeigt-, an jedem Längsschenkel 26 genau eine konzentrierte Wicklung 61 anzuordnen.

Andererseits sind auch Ausgestaltungen möglich, bei denen zur kombinierten Erzeugung der magnetischen Lagerkräfte und eines Drehmoments zum Rotieren des Rotors 3 zwei unterschiedliche Wicklungssysteme vorgesehen sind. Dazu sind dann beispielsweise an jedem Längsschenkel jeweils genau zwei konzentrierte Wicklungen angeordnet, die bezüglich der axialen Richtung A benachbart zueinander angeordnet sind. Eine dieser beiden Wicklungen gehört zu dem ersten der beiden Wicklungssystem und die andere zu dem zweiten der beiden Wicklungssysteme.

Bei der in Fig. 1 dargestellten Ausführungsform mit genau einer konzentrierten Wicklung 61 an jedem Spulenkern 25 werden beispielsweise die in der Kontrolleinheit 40 jeweils ermittelten Werte für den für die Lagerung benötigten Strom und den für die Erzeugung des Drehmoments benötigten Strom rechnerisch -also z. B. mit Hilfe von Software - addiert bzw. überlagert. Der sich daraus ergebende Gesamtstrom wird dann in die jeweilige konzentrierte Wicklung 61 eingeprägt.

In Fig. 3 ist zum besseren Verständnis der Rückschluss 22 getrennt von den Spulenkernen 25 dargestellt. Der Rückschluss 22 ist im Wesentlichen ringförmig ausgestaltet und erstreckt sich im zusammengesetzten Zustand (siehe auch Fig. 1) radial innenliegend entlang der ersten Enden 261 der Längsschenkel 26. Vorzugsweise ist der Rückschluss 22 geblecht ausgestaltet. Bei der geblechten Ausgestaltung ist der Rückschluss 22 aus einer Mehrzahl von dünnen Elementen aufgebaut, die parallel zueinander in axialer Richtung A aufeinander gestapelt sind. Alle Elemente sind identisch ausgestaltet, hier also jeweils im Wesentlichen ringförmig und auch mit der gleichen Dicke.

Der Rückschluss 22 weist an seiner radial äusseren Umfangsfläche eine Mehrzahl von Abflachungen 222 auf, die planar, also nicht gekrümmt ausgestaltet sind. An jeder dieser Abflachungen 222 liegt im zusammengesetzten Zustand des Stators 2 jeweils ein erstes Ende 261 eines der Längsschenkel 26 an, die vorzugsweise ein rechteckiges Profil aufweisen. Durch die planare Ausgestaltung der Abflachungen 222 wird eine grosse Kontaktfläche zwischen dem Rückschluss 22 und den Längsschenkeln 26 der Spulenkerne 25 gewährleistet, woraus eine besonders gute Führung des magnetischen Flusses bzw. ein sehr geringer magnetischer Widerstand an dem Übergang zwischen dem Rückschluss 22 und den Längsschenkeln 26 resultiert. Die Abflachungen können auch an separaten Segmenten 225 angeordnet sein, wobei die separaten Segmente 225 in Nuten des Rückschlusses 22 angeordnet sind. Die Nuten sind so bemessen, dass die separaten Segmente 225 bündig mit dem Rest des Rückschlusses 22 abschliessen.

Vorzugsweise ist die Anzahl der Abflachungen 222 gleich gross wie die Anzahl der Spulenkerne 25, hier sind also sechs Abflachungen 222 vorgesehen, die äquidistant entlang des äusseren Umfangs des Rückschlusses 22 verteilt sind

Ferner können an dem Rückschluss 22 ein oder mehrere Entlüftungsbohrungen oder -ausnehmungen 223 vorgesehen sein, die sich bezüglich der axialen Richtung A vollständig durch den Rückschluss 22 hindurch erstrecken. Durch die Entlüftungsausnehmungen 223 kann beispielsweise beim Ausgiessen des Gehäuses 20 mit einer thermisch leitenden Vergussmasse Luft entweichen.

Um die jeweils aktuelle Position des Rotors 3 in der becherförmigen Ausnehmung 211 zu bestimmen, umfasst die Magnetlagervorrichtung 1 vorzugsweise eine Mehrzahl von Magnetfeldsensoren (nicht dargestellt), welche im zusammengebauten Zustand der Magnetlagervorrichtung 1 um die becherförmige Ausnehmung 211 herum angeordnet sind. Die Magnetfeldsensoren sind Sensoren, mit denen ein Magnetfeld gemessen werden kann. Mit Hilfe der Magnetfeldsensoren kann die aktuelle Position des Rotors 3 in der becherförmigen Ausnehmung 211 des Spalttopfs 21 bzw. in der radialen Ebenen E in an sich bekannter Weise ermittelt werden.

Vorzugsweise sind die Magnetfeldsensoren auf einer Sensorplatine 7 angeordnet und mit dieser über elektrische Verbindungen signalverbunden, sodass alle Magnetfeldsensoren über die Sensorplatine 7 angesteuert werden können und die von den Magnetfeldsensoren gemessenen Signale über die Sensorplatine 7 empfangen und verarbeitet oder beispielsweise an die Kontrolleinrichtung 40 übermittelt werden können.

Die Sensorplatine 7 ist bezüglich der axialen Richtung A zwischen den Wicklungen 61 einerseits und den Querschenkel 27 andererseits angeordnet. Die Halteeinrichtung 9 ist zum Aufnehmen der Sensorplatine 7 ausgestaltet.

Die Sensorplatine 7 umfasst ferner ein elektrisches Verbindungselement 76, welches die Sensorplatine 7 mit der Kontrolleinrichtung 40 verbindet, sodass die Kontrolleinrichtung 40 und die Sensorplatine 7 über das elektrische Verbindungselement 76 elektrische Spannungen oder Ströme austauschen können. Das elektrische Verbindungselement 76 ist vorzugsweise als Flexprint ausgestaltet. Natürlich kann das elektrische Verbindungselement 76 auch anders ausgestaltet sein, beispielsweise als Kabel, als Kabelbündel oder als Flachbandkabel.

Fig. 5 zeigt in einer Schnittdarstellung den Spalttopf 21 des Stators 2 des Ausführungsbeispiels der Magnetlagervorrichtung 1, wobei der Schnitt in der axialen Richtung A erfolgt.

Der Spalttopf 21 mit der becherförmigen Ausnehmung 211 ist vorzugsweise einstückig ausgestaltet. Die becherförmige Ausnehmung hat einen Aussendurchmesser DA, der so bemessen ist, dass der zu lagernde Rotor 3 in die becherförmige Ausnehmung 211 einsetzbar ist. Der Spalttopf 21 ist vorzugsweise aus einem Kunststoff hergestellt und insbesondere bevorzugt aus einem Kunststoff, der mittels Spritzgiessens verarbeitet werden kann. Der Spalttopf 21 ist somit vorzugsweise als ein Spritzgussteil ausgestaltet. Geeignete Kunststoffe für die Herstellung des Spalttopfs 21 sind beispielsweise Acrylnitril-Butadien-Styrol (ABS), Polyamid (Nylon, PA), Polypropylen (PP), Polytetrafluoroethylene (PTFE), Perfluoroalkoxy Alkane (PFA) Polyvinylchlorid (PVC), Polybutylene Terephthalat (PBT), Polyimid (PI), Polyetereterketon , Polysuccinimid (PSI), Polyphthalamid (PPA) oder Polyether Ether Keton (PEEK),

Der Spalttopf 21 umfasst die becherförmige Ausnehmung 211, in welche der Rotor 3 eingesetzt werden kann, und einen radial aussenliegenden Rand 212, welcher im zusammengebauten Zustand den axialen Randbereich 92 der Halteeinrichtung 9 umgreift.

Die Halteeinrichtung 9 ist im Wesentlichen plattenförmig und ringförmig ausgestaltet, und umfasst mehrere Aussparungen 91 (Fig. 4) zum Aufnehmen der Querschenkel 27 der Spulenkerne 25. Für jeden Querschenkel 27 ist genau eine Aussparung 91 vorgesehen, so dass die Anzahl der Aussparungen 91 gleich gross ist wie die Anzahl der Spulenkerne 25. Die Halteeinrichtung 9 wird in den Spalttopf 21 eingesetzt (siehe Fig. 1) und erstreckt sich vom Boden des Spalttopfes 21 in axialer Richtung A bis zu einem darstellungsgemäss (Fig. 1) unteren Rand, der bezüglich der axialen Richtung A darstellungsgemäss oberhalb der Wicklungen 61 angeordnet ist.

Die Halteeinrichtung 9 ist derart ringförmig ausgestaltet, dass sie um die becherförmige Ausnehmung 211 des Spalttopfes 21 herum angeordnet werden kann, dass also die becherförmige Ausnehmung 211 von der Halteeinrichtung 9 radial aussenliegend umschlossen wird.

Die Halteeinrichtung 9 ist vorzugsweise aus einem Kunststoff hergestellt und insbesondere bevorzugt aus einem Kunststoff, der mittels Spritzgiessens verarbeitet werden kann. Die Halteeinrichtung 9 ist somit vorzugsweise als ein Spritzgussteil ausgestaltet. Geeignete Kunststoffe für die Herstellung der Halteeinrichtung 9 sind beispielsweise Acrylnitril-Butadien-Styrol (ABS), Polyamid (Nylon, PA), Polypropylen (PP), oder fasergefülltes Polypropylen.

Die Halteeinrichtung 9 dient sowohl als Halterung für die Sensorplatine 7 mit den Magnetfeldsensoren als auch der Führung und der Halterung der Spulenkerne 25.

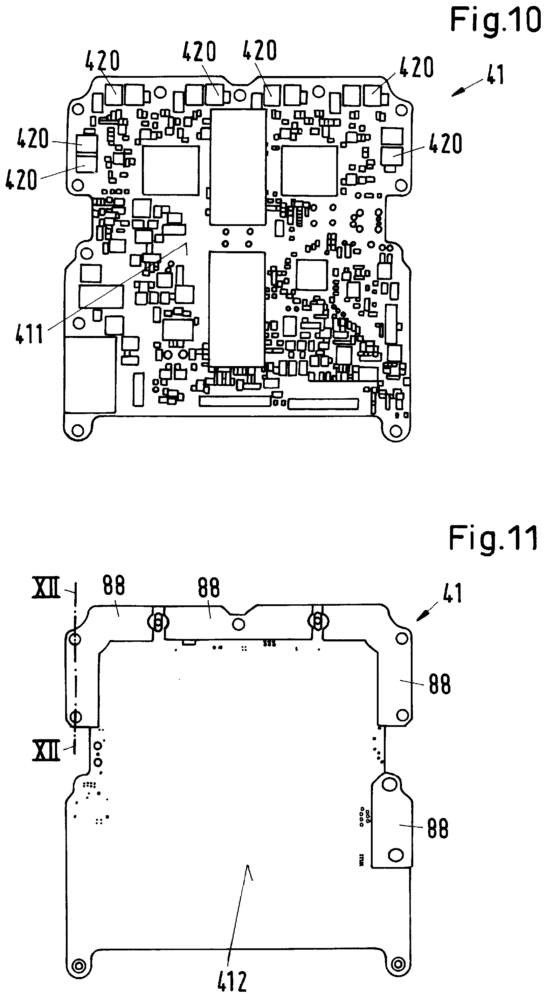

Fig. 6 zeigt eine perspektivische Darstellung des Kontrollgehäuses 102 und der Platine 41 der Kontrolleinrichtung 40. Die Platine 41 hat eine Vorderseite 411 und eine Rückseite 412. Auf der Vorderseite der Platine 41 der Kontrolleinheit 40 sind die elektronischen Komponenten 42 angeordnet, welche für die Ansteuerung und die Versorgung der Wicklungen 61 mit elektrischer Energie notwendig sind. Dies sind insbesondere Leistungsschalter 420 (siehe auch Fig. 10) für die Ansteuerung der Wicklungen 61, mit denen der den Wicklungen 61 zugeführte Strom geschaltet wird. Die elektronischen Komponenten 42 umfassen ferner Regel- und Steuerkomponenten für die Kontrolle der berührungslosen magnetischen Lagerung und optional des berührungslosen magnetischen Antriebs, die an sich bekannt sind und daher hier nicht näher erläutert werden.

Die Leistungsschalter 420 umfassen typischerweise Transistoren, vorzugsweise MOSFETs, mit denen Halbbrücken oder Vollbrücken realisiert werden, welche die Wicklungen 61 des Stators 2 ansteuern. Typischerweise sind eine oder mehrere solcher Halbbrücken- oder Vollbrückenschaltungen in einem Chip-Gehäuse 424 (Fig. 7) des Leistungsschalters 420 angeordnet, wobei optional auch Treiber in dem Chip-Gehäuse 424 vorgesehen sein können. Das Chip-Gehäuse 424 des Leistungsschalters 420 wird dann mittels eines sogenannten Die Attach Paddle (DAP) auf der Vorderseite 411 der Platine 41 befestigt. An dem Chip-Gehäuse 424 des Leistungsschalters 420 sind mehrere Anschlusspins vorgesehen (nicht näher dargestellt), über welche die elektronischen Bauteile des Leistungsschalters 420, also beispielsweise die Transistoren, elektrisch mit Leiterbahnen oder elektrischen Anschlüssen auf der Platine 41 verbunden werden können. Die Chip-Gehäuse 424 der Leistungsschalter 420 werden beispielsweise mittels Klebstoffs oder mittels einer Lötverbindung auf der Platine 41 befestigt.

Zum besseren Verständnis zeigt Fig. 8 eine Aufsicht auf das Kontrollgehäuse 102. Fig. 9 zeigt eine Aufsicht auf die Rückseite 412 der Platine 41, und Fig. 10 zeigt eine Aufsicht auf die Vorderseite 411 der Platine 41.

Wie dies insbesondere in den Fig. 6 und Fig. 8 gut zu erkennen ist, sind auf der Trennwand 103, welche das Kontrollgehäuse 102 begrenzt, und angrenzend an die äussere Wandung 15 des Gehäuses 10 mehrere Stege 8 vorgesehen, welche in das Kontrollgehäuse 102 hineinragen. Vorzugsweise sind die Stege 8 integraler Bestandteil der Trennwand 103 und der äusseren Wandung 15. Besonders bevorzugt bilden das Gehäuse 10, also insbesondere die äussere Wandung 15, die Trennwand 103 und die Stege 8 eine bauliche Einheit, welche vorzugsweise aus einem metallischen Material, beispielsweise Aluminium oder ein Edelstahl, gefertigt ist.

Die Stege 8 sind dort angeordnet, wo die Trennwand 103 an die äussere Wandung 15 angrenzt. Die Stege 8 dienen der Abstützung der Platine 41. Die Platine 41 wird mit ihrer Rückseite 412 auf die Stege 8 aufgelegt und auf den Stegen 8 befestigt, beispielsweise mit einer Mehrzahl von Schrauben, welche durch Schraubenlöcher 82 (Fig. 9) in der Platine 41 hindurchgreifen und in Gewindebohrungen 81 eingreifen, die auf den Stegen 8 angeordnet sind.

Die Stege 8 dienen also als Auflage, auf welcher sich die Rückseite 412 der Platine 41 abstützt. "Auflage" bzw. "aufliegen" ist also so zu verstehen, dass die Stege 8 die Platine 41 stützen, was jedoch nicht bedeuten soll, dass die Rückseite 412 der Platine 41 in direktem körperlichen Kontakt mit den Stegen 8 stehen muss. Es sind natürlich Ausführungsformen möglich, bei denen die Rückseite 412 in direktem körperlichen Kontakt mit den Stegen 8 ist. Es sind aber auch solche Ausgestaltungen möglich, bei welchen die Stege 8 nur teilweise oder auch gar nicht in direktem körperlichen Kontakt mit der Rückseite der Platine 41 stehen, weil zwischen der Rückseite 412 der Platine 41 und den Stegen 8 beispielsweise Kontaktpads 87 oder Wärmeleitschichten 88 angeordnet sein können. Dies wird beispielsweise in den Ausführungsformen in Fig. 10 und Fig. 11 gezeigt. Mit den Bereichen, mit denen sich die Rückseite 412 der Platine 41 auf den Stegen 8 abstützt, sind also diejenigen Bereiche gemeint, welche in axialer Richtung A gesehen die Stege 8 überlappen, wobei es möglich aber keinesfalls notwendig ist, dass diese Bereiche ganz oder teilweise in direktem körperlichen Kontakt mit den Stegen 8 stehen.

Wie dies insbesondere in Fig. 10 zu erkennen ist, ist eine Mehrzahl der Leistungsschalter 420 in demjenigen Bereich auf der Vorderseite 411 der Platine 41 angeordnet, mit dem die Rückseite 412 der Platine 41 auf den Stegen 8 aufliegt. Vorzugsweise sind alle Leistungsschalter 420 in demjenigen Bereich der Platine 41 angeordnet, mit dem die Rückseite 412 der Platine 41 auf den Stegen 8 aufliegt. Ferner sind für jeden Leistungsschalter 420 thermische Verbindungselemente 85 (Fig. 7) vorgesehen, welche den Leistungsschalter 420 thermisch mit dem Steg 8 verbinden, auf welchem derjenige Bereich der Platine 41 aufliegt, auf welchem der jeweilige Leistungsschalter 420 angeordnet ist.

Jedes thermische Verbindungselement 85 ist vorzugsweise als Durchkontaktierung ausgestaltet. Für solche Durchkontaktierungen ist auch der Begriff Thermal Vias üblich. Diese bilden Wärmebrücken, welche sich von der Vorderseite 411 der Platine 41 bis auf die Rückseite 412 der Platine 41 erstrecken.

Vorzugsweise ist für jeden Leistungsschalter 420 eine Mehrzahl von thermischen Verbindungselementen 85 vorgesehen. Dies veranschaulicht die schematische Darstellung in Fig. 7. Fig. 7 zeigt in der rechten Darstellung einen Ausschnitt aus der Rückseite 412 der Platine 41, nämlich den Bereich der Rückseite 412, wo auf der Vorderseite 411 einer der Leistungsschalter 420 angeordnet ist. Es sind insgesamt sechzehn thermische Verbindungselemente 85 vorgesehen, von denen jedes als Durchkontaktierung ausgestaltet ist, welche den Leistungsschalter 420 thermisch mit der Rückseite 412 der Platine 41 und somit mit dem Steg 8 verbindet, auf welchem dieser Bereich der Platine 41 aufliegt. Die sechzehn thermischen Verbindungselemente 85 sind in vier Reihen mit jeweils vier thermischen Verbindungselementen 85 angeordnet. Es versteht sich, dass die Anzahl von sechzehn thermischen Verbindungselementen 85 pro Leistungsschalter beispielhaft zu verstehen ist. Natürlich kann auch eine grössere oder eine kleinere Anzahl als sechzehn thermische Verbindungselementen 85 pro Leistungsschalter 420 vorgesehen sein.

Die linke Darstellung in Fig. 7 zeigt schematisch einen Schnitt durch die Platine 41 mit einem der Leistungsschalter 420, der auf der Vorderseite 411 der Platine 41 angeordnet ist. Vorzugsweise ist für jeden Leistungsschalter 420 auf der Vorderseite 411 der Platine 41 jeweils eine separate Montagefläche 421 vorgesehen, auf welcher der jeweilige Leistungsschalter 420 befestigt ist, beispielsweise mittels einer Lötverbindung. Die Montagefläche 421 besteht vorzugsweise aus einem thermisch gut leitenden Material, beispielsweise aus einem metallischen Material.

Die Leistungsschalter 420 umfassen typischerweise Transistoren, vorzugsweise MOSFETs, mit denen Halbbrücken oder Vollbrücken realisiert werden, welche die Wicklungen 61 des Stators 2 ansteuern. Typischerweise sind eine oder mehrere solcher Halbbrücken- oder Vollbrückenschaltungen in dem Chip-Gehäuse 424 des Leistungsschalters 420 angeordnet, wobei optional auch Treiber in dem Chip-Gehäuse 424 vorgesehen sein können. Das Chip-Gehäuse 424 des Leistungsschalters 420 wird auf der Montagefläche 421 auf der Vorderseite 411 der Platine 41 befestigt. An dem Chip-Gehäuse 424 des Leistungsschalters 420 sind mehrere Anschlusspins vorgesehen (nicht dargestellt), über welche die elektronischen Komponenten des Leistungsschalters 420, also beispielsweise die Transistoren, elektrisch mit Leiterbahnen oder elektrischen Anschlüssen auf der Platine 41, verbunden werden können. Die elektronischen Komponenten des Leistungsschalters 420 sind elektrisch isoliert gegen das Chip-Gehäuse 424. Die Montagefläche 421, die auch als Kühlfläche für den Leistungsschalter 420 dient, liegt üblicherweise auf Erdpotential. Von der Montagefläche 421 erstrecken sich die thermischen Verbindungselement 85 durch die Platine 41 hindurch bis auf die Rückseite 412 der Platine 41.

Im Betriebszustand stellen die Leistungsschalter 420 eine der Hauptwärmequellen, wenn nicht die Hauptwärmequelle der Kontrolleinrichtung 40 dar. Durch die Anordnung der Leistungsschalter 420 in den Bereichen der Platine 41, welche auf den Stegen 8 im Kontrollgehäuse 102 aufliegen, kann die von den Leistungsschaltern generierte Wärme sehr effizient und zuverlässig über die thermischen Verbindungselemente 85 in die Stege 8 und somit in das Gehäuse 10 abgeführt werden, sodass insbesondere die Kontrolleinheit 40 zuverlässig vor Überhitzungen geschützt ist.

Wie dies in Fig. 9 zu erkennen ist, sind vorzugsweise zusätzliche thermische Verbindungselemente 86 vorgesehen, von denen sich jedes von der Vorderseite 411 bis zur Rückseite der Platine 41 erstreckt. Die zusätzlichen thermischen Verbindungselemente 86 sind ausserhalb derjenigen Bereiche angeordnet, in denen sich die separaten Montageflächen 421 für die Leistungsschalter 420 befinden. Die zusätzlichen thermischen Verbindungselemente 86 dienen dazu, gezielt aus anderen Bereichen der Vorderseite 411 der Platine 41 Wärme an die Rückseite 412 der Platine 41 abzuführen. Diese anderen Bereiche sind solche Bereiche, in denen keine Leistungsschalter 420 angeordnet sind. Auch die zusätzlichen thermischen Verbindungselemente 86 sind bevorzugt so angeordnet, dass sie an den Stegen 8 enden, bzw. thermisch an die Stege 8 gekoppelt sind. Jedes zusätzliche thermische Verbindungselement 86 ist vorzugsweise als Durchkontaktierung ausgestaltet.

Eine weitere vorteilhafte Massnahme besteht darin (siehe Fig. 9), dass für jede Montagefläche 421 auf der Rückseite 412 der Platine ein Kontaktpad 87 vorgesehen ist, welches alle thermischen Verbindungselemente 85 thermisch miteinander koppelt, die zu dieser Montagefläche 421 gehören. Jedes Kontaktpad 87 liegt auf einem der Stege 8 auf. Jedes Kontaktpad 87 ist beispielsweise aus Kupfer hergestellt. Jedes Kontaktpad 87 ist beispielsweise als eine Kupferfolie oder als eine Kupferschicht ausgestaltet, welche jeweils die Enden aller thermischen Verbindungselemente 85, die zum gleichen Leistungsschalter 420 gehören, auf der Rückseite 412 der Platine 41 thermisch miteinander verbindet. Durch diese grossflächigen Kontaktpads 87 lässt sich die Wärme besonders gut in die Stege 8 und damit in das Gehäuse 10 ableiten.

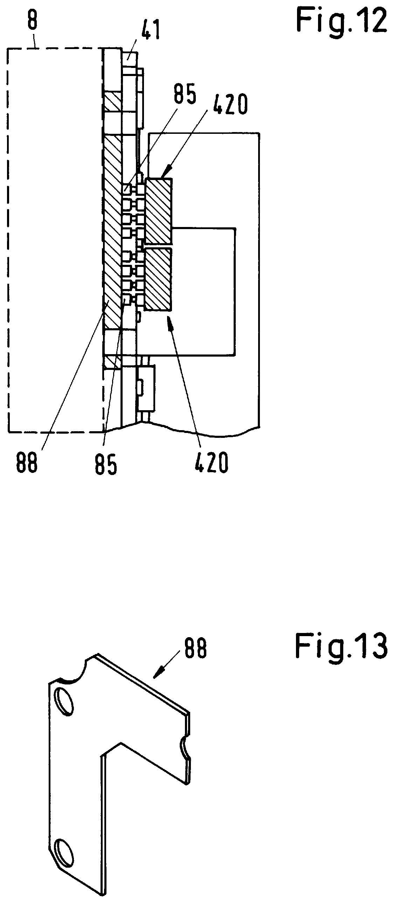

Fig. 11 zeigt eine Aufsicht auf die Rückseite 412 einer Variante für die Platine 41. Zum besseren Verständnis zeigt Fig. 12 eine schematische Schnittdarstellung dieser Variante der Platine 41, wobei der Schnitt entlang der Linie XII-XII in Fig. 11 erfolgt.

Bei dieser Variante ist zwischen der Rückseite 412 der Platine 41 und dem jeweiligen Steg 8, auf welchem die Platine 41 aufliegt, eine Wärmeleitschicht 88 angeordnet, mit welcher Wärme von der Platine 41 auf den jeweiligen Steg 8 und damit auf das Gehäuse 10 übertragbar ist.

Zum besseren Verständnis zeigt Fig. 13 eine perspektivische Darstellung einer der Wärmeleitschichten 88.

Vorzugsweise entspricht die Form der Wärmeleitschicht 88 der Oberfläche des Stegs 8, auf welchem die Wärmeleitschicht 88 aufliegt, sodass die gesamte Oberfläche des Stegs 8, auf welcher die Platine 41 aufliegt, von der Wärmeleitschicht 88 abgedeckt ist.

Die Wärmeleitschicht 88 verbessert die thermische Anbindung an das Gehäuse 10. Vorzugsweise ist die Wärmeleitschicht 88 als Folie aus einem thermisch leitfähigen Material ausgestaltet und wird zwischen der Platine 41 und dem jeweiligen Steg 8 angeordnet, auf welchem die Platine 41 aufliegt. Die als Folie ausgestaltete Wärmeleitschicht 88 kann beispielsweise auf die Rückseite 412 der Platine 41 montiert oder gelötet werden. Es versteht sich, dass mehrere Wärmeleitschichten 88 vorgesehen sein können, sodass zwischen allen Stegen 8, auf denen die Platine 41 aufliegt und der Platine eine solche Wärmeleitschicht 88 angeordnet ist. Durch die Wärmeleitschichten 88 wird die Wärme breitflächig auf die Stege 8 und damit auf das Gehäuse 10 übertragen, wodurch der thermische Übergangswiderstand reduziert wird. Die vorzugsweise als Folien ausgestalteten Wärmeleitschichten 88 sind aus einem thermisch gut leitfähigen sowie leicht verformbaren (duktilen) Material gefertigt, sodass die Wärmeleitschichten 88 auch kleine Unebenheiten und mechanische Toleranzen ausgleichen können. Insbesondere geeignet für die Wärmeleitschichten 88 sind metallische Materialien, beispielsweise Kupfer oder Silber. Die Wärmeleitschichten 88 als Kupferfolien auszugestalten hat den Vorteil, dass sie sich gut löten lassen. Um die Lötbarkeit weiter zu verbessern, können die Kupferfolien auch mit einem Edelmetall, beispielsweise mit Gold, beschichtet werden.

Im Folgenden wird nun noch erläutert, wie die Magnetlagervorrichtung 1 in sehr einfacher Weise zusammengebaut werden kann. Der Zusammenbau kann beispielsweise wie folgt durchgeführt werden. Die Sensorplatine 7 mit den darauf angeordneten und befestigten Magnetfeldsensoren wird in die Halteeinrichtung 9 eingefügt.

Anschliessend kann die Halteeinrichtung 9 vollständig mit einer Vergussmasse ausgegossen, derart, dass die Sensorplatine 7 vollständig von der Vergussmasse bedeckt ist.

Die Spulenkerne 25 werden durch die Aussparungen 91 in der Halteeinrichtung 9 hindurchgeführt und durch die konzentrierten Wicklungen 61. Der magnetische Rückschluss 22 wird zwischen den ersten Enden 261 der Längsschenkel 26 angeordnet. Die Halteeinrichtung 9, der Rückschluss 22 und die Spulenkerne 25 mit den darauf angeordneten konzentrierten Wicklungen 61 werden in einer ersten Einbaurichtung in axialer Richtung A (gemäss der Darstellung in Fig. 2 von der linken Seite) in das Statorgehäuse 101 des Gehäuses 10 eingeführt. Dabei wir das elektrische Verbindungselement 76 parallel zu den Längsschenkeln 26 der Spulenkerne 25 durch das Statorgehäuse 101 bis in das Kontrollgehäuse 102 geführt.

Wenn die Halteeinrichtungen 9, die Wicklungen 61, der Rückschluss 22 und die Spulenkerne 25 in dem Statorgehäuse 101 des Gehäuses 10 angeordnet sind, wird der Spalttopf 21 auf das Gehäuse 10 aufgesetzt und dichtend, vorzugsweise hermetisch dicht, mit dem Gehäuse 10 verbunden, wobei zwischen dem Spalttopf 21 und dem Gehäuse 10 die Dichtung 201 angeordnet wird.

Anschliessend wird das Gehäuse 10 der Magnetlagervorrichtung 1 mit einer thermisch leitenden Vergussmasse ausgegossen. Die thermische Vergussmasse hat vorzugsweise eine besonders gute thermische Leitfähigkeit, um die im Betriebszustand generierte Wärme schnell und zuverlässig in das Gehäuse 10 abzuleiten, von wo die Wärme dann hauptsachlich mittels Konvektion abgeführt wird. Als thermisch leitende Vergussmasse sind beispielsweise Polyurethane, Epoxidharze, Acrylharze oder Polyester geeignet.

Nachdem das Statorgehäuse 101 des Gehäuses 10 mit der zweiten Vergussmasse ausgegossen ist, wird die Kontrolleinheit 40 in einer zweiten Einbaurichtung in das Kontrollgehäuse 102 des Gehäuses 10 eingesetzt, wobei die zweite Einbaurichtung entgegengesetzt zur ersten Einbaurichtung ist. Gemäss der Darstellung in Fig. 2 wird also die Kontrolleinheit 40 von rechts in das Kontrollgehäuse 102 eingesetzt. Das elektrische Verbindungselement 76 wird mit der Kontrolleinheit 40 verbunden.

Wenn die Kontrolleinheit 40 in dem Kontrollgehäuse 102 des Gehäuses 10 angeordnet ist, wird der Gehäusedeckel 11 auf das Gehäuse 10 aufgesetzt und dichtend, vorzugsweise hermetisch dicht, mit dem Gehäuse 10 verbunden, wobei zwischen dem Gehäusedeckel 11 und dem Gehäuse 10 das Dichtungselement 105 angeordnet wird. Der Gehäusedeckel 11 wir beispielsweise mittels mehrerer Schrauben 111 (Fig. 1) am Gehäuse 10 befestigt.

Optional kann auch das Kontrollgehäuse 102 des Gehäuses 10 mit einer Vergussmasse ausgegossen werden, beispielsweise für Anwendungen mit stark korrosiven oder aggressiven oder explosiven Fluiden. Falls auch das Kontrollgehäuse 102 ausgegossen wird, so erfolgt dies, bevor der Gehäusedeckel 11 auf das Gehäuse 10 aufgesetzt und fest mit diesem verbunden wird.

Die erfindungsgemässe Magnetlagervorrichtung 1 ist insbesondere für Zentrifugalpumpen geeignet, sowie für Mischvorrichtungen zum Mischen fliessfähiger Substanzen, für Rührvorrichtungen, beispielsweise zum Durchmischen eines Fluids in einem Tank, für Lüfter oder auch für Vorrichtungen zum Tragen und Rotieren von Wafern, beispielsweise in der Halbleiterfertigung.

## Patentansprüche

1. Magnetlagervorrichtung zur berührungslos magnetischen Lagerung eines Rotors (3), der einen scheibenförmigen oder ringförmigen magnetisch wirksamen Kern (31) umfasst, wobei die Magnetlagervorrichtung ein Gehäuse (10), einen Stator (2) und eine Kontrolleinrichtung (40) umfasst,
wobei der Stator (2) eine Mehrzahl von Spulenkernen (25) umfasst, von denen jeder einen Längsschenkel (26) aufweist, welcher sich von einem ersten Ende (261) in einer axialen Richtung (A) bis zu einem zweiten Ende (262) erstreckt, sowie einen Querschenkel (27), welcher an dem zweiten Ende (262) des Längsschenkels angeordnet ist, und sich in einer radialen Richtung erstreckt, die senkrecht zur axialen Richtung (A) ist, wobei an jedem Längsschenkel (26) mindestens eine konzentrierte Wicklung (61) vorgesehen ist, welche den jeweiligen Längsschenkel (26) umgibt, wobei der Stator (2) ferner eine becherförmige Ausnehmung (211) aufweist, in welche der Rotor (3) einsetzbar ist, wobei die becherförmige Ausnehmung (211) an einem axialen Ende des Stators (2) angeordnet ist,
wobei die Kontrolleinheit (40) eine Platine (41) mit einer Vorderseite (411) und einer Rückseite (412) umfasst, wobei auf der Vorderseite (411) Leistungsschalter (420) zur Ansteuerung der Wicklungen (61) angeordnet sind,
wobei das Gehäuse (10) eine äussere Wandung (15) umfasst, ein Statorgehäuse (101) zum Aufnehmen des Stators (2), ein Kontrollgehäuse (102) zum Aufnehmen der Kontrolleinheit (40), sowie eine Trennwand (103), welche das Statorgehäuse (101) vom Kontrollgehäuse (102) trennt,
**dadurch gekennzeichnet, dass** auf der Trennwand (103) und benachbart zu der äusseren Wandung (15) mindestens ein Steg (8) angeordnet ist, welcher in das Kontrollgehäuse (102) ragt, wobei sich die Rückseite (412) der Platine (41) auf dem Steg (8) abstützt, wobei eine Mehrzahl der Leistungsschalter (420) in dem Bereich der Platine (8) angeordnet ist, mit welchem sich die Rückseite (412) der Platine (41) auf dem Steg (8) abstützt, und wobei zwischen der Mehrzahl von Leistungsschaltern (420) und dem Steg (8) thermische Verbindungselemente (85) zum Abführen von Wärme vorgesehen sind.

2. Magnetlagervorrichtung nach Anspruch 1, bei welcher die äussere Wandung (15) des Gehäuses (10), die Trennwand (103) und der Steg (8) als einstückige Einheit ausgestaltet sind.

3. Magnetlagervorrichtung nach einem der vorangehenden Ansprüche, wobei jeder Leistungsschalter (420) auf einer jeweils separaten Montagefläche (421) angeordnet ist, wobei jede Montagefläche (421) über eine Mehrzahl der thermischen Verbindungselemente (85) mit der Rückseite (412) der Platine (41) verbunden ist, und wobei sich jedes thermische Verbindungselement (85) von der Vorderseite (411) bis zur Rückseite (412) der Platine (41) erstreckt.

4. Magnetlagervorrichtung nach Anspruch 3, wobei zusätzliche thermische Verbindungselemente (86) vorgesehen sind, von denen sich jedes von der Vorderseite (411) bis zur Rückseite (412) der Platine (41) erstreckt, wobei jedes zusätzliche thermische Verbindungselement (86) ausserhalb der separaten Montageflächen (421) angeordnet ist.

5. Magnetlagervorrichtung nach einem der Ansprüche 3-4, wobei für jede Montagefläche (421) jeweils auf der Rückseite (412) der Platine (41) ein Kontaktpad (87) vorgesehen ist, welches alle thermischen Verbindungselemente (85) thermisch miteinander koppelt, die zu dieser Montagefläche (421) gehören.

6. Magnetlagervorrichtung nach einem der vorangehenden Ansprüche, wobei zwischen dem Steg (8) und der Rückseite (412) der Platine (41) eine Wärmeleitschicht (88) angeordnet ist, mit welcher Wärme von der Platine (41) auf das Gehäuse (10) übertragbar ist.

7. Magnetlagervorrichtung nach Anspruch 6, wobei die Wärmeleitschicht (88) als Folie ausgestaltet ist, welche auf der Rückseite (412) der Platine (41) befestigt ist.

8. Magnetlagervorrichtung nach einem der Ansprüche 6-7, wobei die Wärmeleitschicht (88) aus einem metallischen Material besteht.

9. Magnetlagervorrichtung nach einem der vorangehenden Ansprüche, wobei das Kontrollgehäuse (102) des Gehäuses (10) mit einem Innenraum ausgestaltet ist, der eine im Wesentlichen rechteckige oder quadratische Querschnittsfläche senkrecht zur axialen Richtung (A) hat.

10. Magnetlagervorrichtung nach einem der vorangehenden Ansprüche, wobei das Statorgehäuse (101) des Gehäuses (10) mit einem Innenraum ausgestaltet ist, der eine im Wesentlichen runde Querschnittsfläche senkrecht zur axialen Richtung (A) hat.

11. Magnetlagervorrichtung nach einem der vorangehenden Ansprüche, wobei an einem axialen Ende der Magnetlagervorrichtung ein Gehäusedeckel (11) angeordnet ist, welcher das Kontrollgehäuse (102) verschliesst.

12. Magnetlagervorrichtung nach einem der vorangehenden Ansprüche, wobei der Stator (2) einen Spalttopf (21) umfasst, welcher ein axiales Ende des Stators (2) bildet, wobei der Spalttopf (21) die becherförmige Ausnehmung (211) aufweist.

13. Magnetlagervorrichtung nach einem der vorangehenden Ansprüche, wobei die Trennwand (103) einen Innenbecher (13) umfasst, der im Wesentlichen zylindrisch ausgestaltet ist, und der radial innenliegend bezüglich der Wicklungen (61) in dem von den Wicklungen (61) umgebenen Innenraum angeordnet ist.

14. Magnetlagervorrichtung nach einem der vorangehenden Ansprüche, wobei das Gehäuse (10) derart ausgestaltet ist, dass die Spulenkerne (25) mit den darauf angeordneten konzentrierten Wicklungen (61) in einer ersten Einbaurichtung in axialer Richtung (A) in das Statorgehäuse (101) einführbar sind, und die Kontrolleinheit (40) in einer zweiten Einbaurichtung in das Kontrollgehäuse (102) einführbar ist, wobei die erste Einbaurichtung entgegengesetzt zur zweite Einbaurichtung gerichtet ist.

15. Magnetlagervorrichtung nach einem der vorangehenden Ansprüche, wobei der Stator (2) zur Erzeugung eines Drehmoments ausgestaltet ist, mit welchem der Rotor (3) berührungslos magnetisch zur Rotation um die axiale Richtung (A) antreibbar ist.

## Claims

1. A magnetic levitation device for contactless magnetic levitation of a rotor (3) comprising a disk-shaped or ring-shaped magnetically effective core (31), wherein the magnetic levitation device comprises a housing (10), a stator (2) and a control device (40),
wherein the stator (2) comprises a plurality of coil cores (25), each of which has a longitudinal leg (26) extending from a first end (261) in an axial direction (A) to a second end (262), and a transverse leg (27) which is arranged at the second end (262) of the longitudinal leg, and which extends in a radial direction perpendicular to the axial direction (A), wherein at least one concentrated winding (61) is provided at each longitudinal leg (26), which winding surrounds the respective longitudinal leg (26), wherein the stator (2) further has a cup-shaped recess (211) into which the rotor (3) can be inserted, wherein the cup-shaped recess (211) is arranged at an axial end of the stator (2),
wherein the control unit (40) comprises a circuit board (41) with a front side (411) and a back side (412), wherein circuit breakers (420) for controlling the windings (61) are arranged on the front side (411),
wherein the housing (10) comprises an outer wall (15), a stator housing (101) for receiving the stator (2), a control housing (102) for receiving the control unit (40), and a separating wall (103) which separates the stator housing (101) from the control housing (102),
**characterized in that** at least one web (8) is arranged on the separating wall (103) and adjacent to the outer wall (15), which web projects into the control housing (102), wherein the back side (412) of the circuit board (41) is supported on the web (8), wherein a plurality of the circuit breakers (420) is arranged in the area of the circuit board (8) with which the back side (412) of the circuit board (41) is supported on the web (8), and wherein thermal connecting elements (85) for dissipating heat are provided between the plurality of circuit breakers (420) and the web (8).

2. The magnetic levitation device according to claim 1, in which the outer wall (15) of the housing (10), the separating wall (103) and the web (8) are designed as a single-piece unit.

3. The magnetic levitation device according to any one of the preceding claims, wherein each circuit breaker (420) is arranged on a respective separate mounting surface (421), wherein each mounting surface (421) is connected to the back side (412) of the circuit board (41) via a plurality of the thermal connecting elements (85), and wherein each thermal connecting element (85) extends from the front side (411) to the back side (412) of the circuit board (41).

4. The magnetic levitation device according to claim 3, wherein additional thermal connecting elements (86) are provided, each of which extends from the front side (411) to the back side (412) of the circuit board (41), wherein each additional thermal connecting element (86) is arranged outside the separate mounting surfaces (421).

5. The magnetic levitation device according to any one of the claims 3 to 4, wherein for each mounting surface (421) a contact pad (87) is provided in each case on the back side (412) of the circuit board (41), which thermally couples all thermal connecting elements (85) belonging to this mounting surface (421) to each other.

6. The magnetic levitation device according to any one of the preceding claims, wherein a heat conducting layer (88) is arranged between the web (8) and the back side (412) of the circuit board (41), with which heat can be transferred from the circuit board (41) to the housing (10).

7. The magnetic levitation device according to claim 6, wherein the heat conducting layer (88) is designed as a film which is attached to the back side (412) of the circuit board (41).

8. The magnetic levitation device according to any one of the claims 6 to 7, wherein the heat conducting layer (88) is made of a metallic material.

9. The magnetic levitation device according to any one of the preceding claims, wherein the control housing (102) of the housing (10) is designed with an interior space having a substantially rectangular or square cross-sectional area perpendicular to the axial direction (A).

10. The magnetic levitation device according to any one of the preceding claims, wherein the stator housing (101) of the housing (10) is designed with an interior space having a substantially round cross-sectional area perpendicular to the axial direction (A).

11. The magnetic levitation device according to any one of the preceding claims, wherein a housing cover (11) is arranged at one axial end of the magnetic levitation device, which cover closes the control housing (102).

12. The magnetic levitation device according to any one of the preceding claims, wherein the stator (2) comprises a containment can (21) which forms one axial end of the stator (2), wherein the containment can (21) has the cup-shaped recess (211).

13. The magnetic levitation device according to any one of the preceding claims, wherein the separating wall (103) comprises an inner cup (13) which is substantially designed in a cylindrical manner, and which is arranged radially inwardly with respect to the windings (61) in the interior space surrounded by the windings (61).

14. The magnetic levitation device according to any one of the preceding claims, wherein the housing (10) is designed in such a way that the coil cores (25) with the concentrated windings (61) arranged thereon can be inserted into the stator housing (101) in a first installation direction in the axial direction (A), and the control unit (40) can be inserted into the control housing (102) in a second installation direction, wherein the first installation direction is directed in the opposite direction to the second installation direction.

15. The magnetic levitation device according to any one of the preceding claims, wherein stator (2) is designed to generate a torque with which the rotor (3) can be driven magnetically without contact for rotation about the axial direction (A).

## Revendications

1. Dispositif à lévitation magnétique pour la lévitation magnétique sans contact d'un rotor (3), qui comprend un noyau (31) magnétiquement actif en forme de disque ou annulaire, le dispositif à lévitation magnétique comprenant un boîtier (10), un stator (2) et une unité de commande (40), le stator (2) comprenant une pluralité de noyaux de bobine (25), dont chacun présente une branche longitudinale (26), qui s'étend d'une première extrémité (261) dans une direction axiale (A) jusqu'à une deuxième extrémité (262), ainsi qu'une branche transversale (27), qui est disposée au niveau de la deuxième extrémité (262) de la branche longitudinale, et s'étend dans une direction radiale, qui est perpendiculaire à la direction axiale (A), au moins un enroulement concentré (61) étant prévu au niveau de chaque branche longitudinale (26), lequel entoure la branche longitudinale (26) respective, le stator (2) présentant en outre un évidement en forme de godet (211), dans lequel le rotor (3) peut être inséré, l'évidement en forme de godet (211) étant disposé au niveau d'une extrémité axiale du stator (2),
l'unité de commande (40) comprenant une platine (41) avec un côté avant (411) et un côté arrière (412), des commutateurs de puissance (420) pour la commande des enroulements (61) étant disposés sur le côté avant (411),
le boîtier (10) comprenant une paroi extérieure (15), un boîtier de stator (101) pour la réception du stator (2), un boîtier de commande (102) pour la réception de l'unité de commande (40), ainsi qu'une paroi de séparation (103), qui sépare le boîtier de stator (101) du boîtier de commande (102),
**caractérisé en ce qu'**au moins une nervure (8) est disposée sur la paroi de séparation (103) et de manière adjacente à la paroi extérieure (15), laquelle nervure fait saillie dans le boîtier de commande (102), le côté arrière (412) de la platine (41) s'appuyant sur la nervure (8), une pluralité des commutateurs de puissance (420) étant disposés dans la région de la platine (8), avec laquelle le côté arrière (412) de la platine (41) s'appuie sur la nervure (8), et des éléments de liaison thermique (85) pour l'évacuation de chaleur étant prévus entre la pluralité de commutateurs de puissance (420) et la nervure (8).

2. Dispositif à lévitation magnétique selon la revendication 1, dans lequel la paroi extérieure (15) du boîtier (10), la paroi de séparation (103) et la nervure (8) sont configurées sous forme d'unité d'une seule pièce.

3. Dispositif à lévitation magnétique selon l'une quelconque des revendications précédentes, dans lequel chaque commutateur de puissance (420) est disposé sur une surface de montage (421) respectivement séparée, chaque surface de montage (421) étant connectée par le biais d'une pluralité des éléments de liaison thermique (85) au côté arrière (412) de la platine (41), et chaque élément de liaison thermique (85) s'étendant du côté avant (411) jusqu'au côté arrière (412) de la platine (41).

4. Dispositif à lévitation magnétique selon la revendication 3, dans lequel des éléments de liaison thermique (86) supplémentaires sont prévus, dont chacun s'étend du côté avant (411) jusqu'au côté arrière (412) de la platine (41), chaque élément de liaison thermique (86) supplémentaire étant disposé à l'extérieur des surfaces de montage (421) séparées.

5. Dispositif à lévitation magnétique selon l'une quelconque des revendications 3 à 4, dans lequel un plot de contact (87) est prévu pour chaque surface de montage (421) respectivement sur le côté arrière (412) de la platine (41), lequel plot de contact couple thermiquement l'un à l'autre tous les éléments de liaison thermique (85) qui appartiennent à cette surface de montage (421).

6. Dispositif à lévitation magnétique selon l'une quelconque des revendications précédentes, dans lequel une couche thermo-conductrice (88) est disposée entre la nervure (8) et le côté arrière (412) de la platine (41), avec laquelle couche thermo-conductrice de la chaleur peut être transmise de la platine (41) au boîtier (10).

7. Dispositif à lévitation magnétique selon la revendication 6, dans lequel la couche thermo-conductrice (88) est configurée sous forme de film, qui est fixé sur le côté arrière (412) de la platine (41).

8. Dispositif à lévitation magnétique selon l'une quelconque des revendications 6 à 7, dans lequel la couche thermo-conductrice (88) se compose d'un matériau métallique.

9. Dispositif à lévitation magnétique selon l'une quelconque des revendications précédentes, dans lequel le boîtier de commande (102) du boîtier (10) est configuré avec un espace intérieur, qui a une surface de section transversale essentiellement rectangulaire ou carrée perpendiculairement à la direction axiale (A).

10. Dispositif à lévitation magnétique selon l'une quelconque des revendications précédentes, dans lequel le boîtier de stator (101) du boîtier (10) est configuré avec un espace intérieur, qui a une surface de section transversale essentiellement ronde perpendiculairement à la direction axiale (A).

11. Dispositif à lévitation magnétique selon l'une quelconque des revendications précédentes, dans lequel un couvercle de boîtier (11) est disposé au niveau d'une extrémité axiale du dispositif à lévitation magnétique, lequel couvercle de boîtier ferme le boîtier de commande (102).

12. Dispositif à lévitation magnétique selon l'une quelconque des revendications précédentes, dans lequel le stator (2) comprend une cloche de confinement (21), qui forme une extrémité axiale du stator (2), la cloche de confinement (21) présentant l'évidement en forme de godet (211).

13. Dispositif à lévitation magnétique selon l'une quelconque des revendications précédentes, dans lequel la paroi de séparation (103) comprend un godet intérieur (13), qui est configuré essentiellement cylindrique, et qui est disposé radialement à l'intérieur par rapport aux enroulements (61) dans l'espace intérieur entouré par les enroulements (61).

14. Dispositif à lévitation magnétique selon l'une quelconque des revendications précédentes, dans lequel le boîtier (10) est configuré de telle sorte que les noyaux de bobine (25) avec les enroulements concentrés (61) disposés sur ceux-ci peuvent être introduits dans une première direction de montage dans la direction axiale (A) dans le boîtier de stator (101), et l'unité de commande (40) peut être introduite dans une deuxième direction de montage dans le boîtier de commande (102), la première direction de montage étant orientée à l'opposé de la deuxième direction de montage.

15. Dispositif à lévitation magnétique selon l'une quelconque des revendications précédentes, dans lequel le stator (2) est configuré pour générer un couple, avec lequel le rotor (3) peut être entraîné magnétiquement sans contact pour la rotation autour de la direction axiale (A).
